# EUROPEAN PATENT APPLICATION

(11) **EP 4 604 123 A1**
(43) Date of publication of application: **20.08.2025**
(21) Application number: 25153268.5
(22) Date of filing: 22.01.2025
(51) Int. Cl.: G11C 7/10, G11C 11/22, G11C 11/56

(54) **MEMORY DEVICE**

(30) Priority: 16.02.2024 KR 20240022938
(71) Applicant: Samsung Electronics Co., Ltd., Suwon-si, Gyeonggi-do 16677 (KR)
(72) Inventor: JEONG, Haewook, 16677 Suwon-si, Gyeonggi-do (KR); PARK, Keonhee, 16677 Suwon-si, Gyeonggi-do (KR)
(74) Representative: Kuhnen & Wacker Patent- und Rechtsanwaltsbüro PartG mbB

(57) **Abstract**

A memory device (100) includes a memory cell array (110) including ferroelectric memory cells (MC), respectively disposed at intersections of wordlines (WL0-WLm) and bitlines (BL0-BLn), and an analog-to-digital converter (120) that is selectively connected to the bitlines (BL0-BLn) and that outputs a digital value corresponding to charges applied through a bitline of the bitlines (BL0-BLn). The charges correspond to a piece of multi-bit data having digits stored in a portion of the ferroelectric memory cells (MC) that are connected to the bitline.

## Description

### BACKGROUND

Example embodiments relate to a memory device.

Due to the demand for high speed and low power consumption in recent electronic products, memory devices embedded in electronic products are also required to have high operation speed and low power consumption. As a result, research into ferroelectric memory devices is being conducted.

Ferroelectric random access memory (FeRAM), also known as FRAM, has a structure and operation principle, similar to those of dynamic random access memory (DRAM). Therefore, FeRAM may provide high-speed read and write operations. In addition, FeRAM utilizes ferroelectric materials with spontaneous polarization. This use of ferroelectric materials and spontaneous polarization allows FeRAM to have nonvolatile characteristics in which stored data is retained even when the power supply to a cell is interrupted. Such nonvolatile characteristics make FeRAM a promising candidate for next-generation memory applications.

With the recent development of artificial intelligence (AI) technology, research is ongoing to develop memory devices having not only read and write functions but also operation functions for stored data.

### SUMMARY

It is an aspect to provide a ferroelectric memory device having operation functions for stored data.

According to an aspect of one or more example embodiments, there is provided a memory device comprising a memory cell array comprising a plurality of ferroelectric memory cells, respectively disposed at intersections of wordlines and bitlines; and an analog-to-digital converter (ADC) selectively connected to the bitlines and configured to output a digital value corresponding to charges applied through at least one bitline of the bitlines. The charges correspond to at least one piece of multi-bit data having a plurality of digits stored in a portion of the plurality of ferroelectric memory cells that are connected to the at least one bitline.

According to another aspect of one or more example embodiments, there is provided a memory device comprising a memory cell array comprising a plurality of ferroelectric memory cells; and an analog-to-digital converter (ADC) respectively and selectively connected to bitlines that are connected to the plurality of ferroelectric memory cells, the ADC being configured to output a digital value corresponding to charges applied through a bitline of the bitlines. Each of the plurality of ferroelectric memory cells comprises an access transistor, and a plurality of ferroelectric capacitors. The plurality of ferroelectric capacitors correspond to a plurality of digits of multi-bit data, respectively.

According to yet another aspect of one or more example embodiments, there is provided a memory device comprising a memory cell array comprising a plurality of ferroelectric memory cells; and an analog-to-digital converter (ADC) respectively and selectively connected to bitlines that are connected to the plurality of ferroelectric memory cells, the ADC being configured to output a digital value corresponding to charges applied through a bitline of the bitlines. The plurality of ferroelectric memory cells comprise a plurality of types of ferroelectric memory cells, respectively corresponding to a plurality of digits of multi-bit data, and the plurality of types of ferroelectric memory cells each comprise a same number of ferroelectric capacitors having a same capacitance, and are controlled by a different number of plate lines depending on corresponding digits of the plurality of digits.

### BRIEF DESCRIPTION OF DRAWINGS

FIG. 1 is a block diagram of a memory device according to an example embodiment.
FIG. 2 is a diagram illustrating a configuration of a ferroelectric memory cell according to an example embodiment.
FIG. 3 is a diagram illustrating a ferroelectric capacitor according to an example embodiment.
FIG. 4A is a diagram illustrating a program operation of a ferroelectric memory cell according to an example embodiment.
FIG. 4B is a diagram illustrating a program operation of a ferroelectric memory cell according to an example embodiment.
FIG. 5A is a diagram illustrating a read operation of a ferroelectric memory cell according to an example embodiment.
FIG. 5B is a diagram illustrating a read operation of a ferroelectric memory cell according to an example embodiment.
FIG. 5C is a diagram illustrating a read operation of a ferroelectric memory cell according to an example embodiment.
FIG. 6 is a block diagram of a memory device according to an example embodiment.
FIG. 7 is a diagram illustrating selective connection of an analog-to-digital converter (ADC) according to an example embodiment.
FIG. 8 is a block diagram of a memory device according to an example embodiment.
FIG. 9 is a block diagram of a memory device according to an example embodiment.
FIG. 10A is a diagram illustrating examples of how to implement a plurality of ferroelectric capacitors in the memory device of FIG. 9, according to an example embodiment.
FIG. 10B is a diagram illustrating examples of how to implement a plurality of ferroelectric capacitors in the memory device of FIG. 9, according to an example embodiment.
FIG. 11 is a block diagram of a memory device according to an example embodiment.
FIG. 12 is a diagram illustrating a configuration and an operation of an ADC according to an example embodiment.
FIG. 13 is a diagram illustrating an addition operation according to an example embodiment.
FIG. 14A is a diagram illustrating a multiplication operation according to an example embodiment.
FIG. 14B is a diagram illustrating a multiplication operation according to an example embodiment.
FIG. 15A is a diagram illustrating various cases in which an operation is performed according to various example embodiments.
FIG. 15B is a diagram illustrating various cases in which an operation is performed according to example embodiments.
FIG. 15C is a diagram illustrating various cases in which an operation is performed according to example embodiments.
FIG. 15D is a diagram illustrating various cases in which an operation is performed according to example embodiments.
FIG. 16 is a block diagram of a memory device according to an example embodiment.
FIG. 17 is a graph illustrating a bitline voltage according to an example embodiment.
FIG. 18 is a block diagram of a memory device according to an example embodiment.
FIG. 19 is a block diagram of a memory device according to an example embodiment.
FIG. 20 is a flowchart illustrating an example of a method of operating the memory device of FIG. 19, according to an example embodiment.
FIG. 21 is a flowchart illustrating an example of a method of operating the memory device of FIG. 19, according to an example embodiment.
FIG. 22 is a block diagram of a memory device according to an example embodiment.
FIG. 23 is a flowchart illustrating an example of a method of operating the memory device of FIG. 22, according to an example embodiment.
FIG. 24 is a flowchart illustrating an example of a method of operating the memory device of FIG. 22, according to an example embodiment.

### DETAILED DESCRIPTION

Hereinafter, various example embodiments will be described in detail with reference to the accompanying drawings. The example embodiments, however, may be embodied in various different forms, and should not be construed as being limited to only the illustrated embodiments. Rather, the illustrated embodiments are provided as examples so that this disclosure will be thorough and complete, and will fully convey the concepts of this disclosure to those of ordinary skill in the art.

The terms such as "first" and "second" as used herein may modify various elements regardless of an order and/or importance of the corresponding elements, but do not limit the corresponding elements. These terms may be used for the purpose of distinguishing one element from another element. For example, a "first" user device and a "second" user device may indicate different user devices regardless of the order or importance. For example, a "first" element may be referred to as a "second" element, and similarly, a "second" element may be referred to as a "first" element. As used in this specification, the phrase "at least one of A, B, or C" includes within its scope "only A", "only B", "only C", "A and B", "A and C", "B and C" and "A, B, and C."

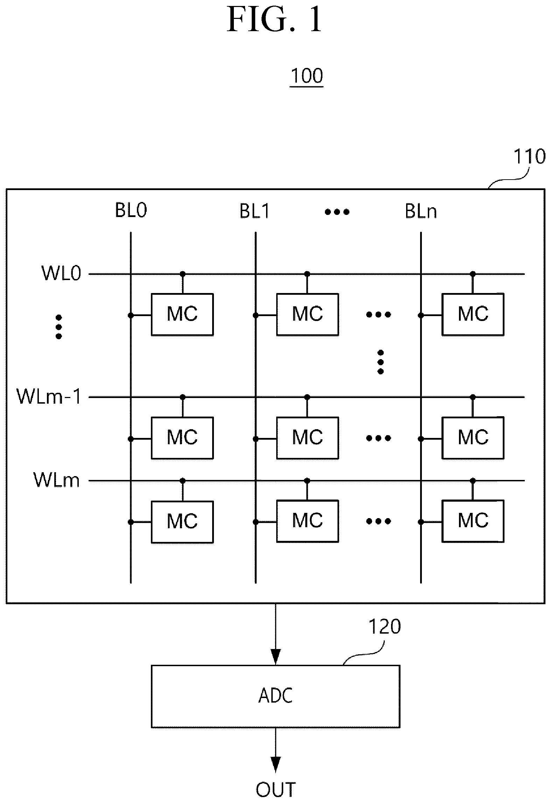

FIG. 1 is a block diagram of a memory device according to an example embodiment. Referring to FIG. 1, a memory device 100 may include a memory cell array 110 and an analog-to-digital converter (ADC) 120.

The memory cell array 110 may include a plurality of ferroelectric memory cells MCs. In an example embodiment, the memory device 100 may be referred to as a ferroelectric random access memory (FeRAM), or an FRAM.

The plurality of ferroelectric memory cells MCs may be disposed at intersections of wordlines WL0 to WLm and bitlines BL0 to BLn, and may be arranged in a matrix. Each ferroelectric memory cell MC may be connected to a corresponding wordline WL and a corresponding bitline BL. Although not illustrated in FIG. 1, each ferroelectric memory cell MC may be connected to at least one plate line PL (see below). The at least one plate line PL may be disposed to correspond to each wordline WL, but example embodiments are not limited thereto.

Each ferroelectric memory cell MC may include an access transistor and a plurality of ferroelectric capacitors, as will be described further below. The plurality of ferroelectric capacitors included in each ferroelectric memory cell MC may store and discharge charges corresponding to data.

In an example embodiment, the plurality of ferroelectric memory cells MCs may store multi-bit data having a plurality of digits. According to example embodiments, one piece of multi-bit data may be stored in a single ferroelectric memory cell or a plurality of ferroelectric memory cells. In other words, in some embodiments, a plurality of digits constituting one piece of multi-bit data may be stored in a single ferroelectric memory cell. In some embodiments, the plurality of digits constituting one piece of multi-bit data may be stored in a plurality of ferroelectric memory cells. This operation will be described in more detail later.

Ferroelectric memory cell(s) storing multi-bit data may store charges corresponding to multi-bit data using ferroelectric capacitors included in ferroelectric memory cell(s), and discharge the stored charges through a bitline connected to the ferroelectric memory cell(s).

The ADC 120 may be selectively connected to at least one bitline among bitlines BL0 to BLn and may output a digital value OUT corresponding to charges applied through the connected at least one bitline. In an example embodiment, the ADC 120 may be selectively connected to a bitline and may output a digital value OUT corresponding to charges applied through the connected bitline. In an example embodiment, the ADC 120 may be selectively connected to two or more bitlines and may output a digital value OUT corresponding to charges applied through the connected bitlines. The digital value OUT output by the ADC 120 may be determined based on charges applied through the connected bitline. Therefore, when the ADC 120 is applied with charges corresponding to a plurality of pieces of multi-bit data, the ADC 120 may output a result obtained by performing an operation on the plurality of pieces of multi-bit data as a digital value.

For example, in an example embodiment, in an addition operation mode, the ADC 120 may receive a voltage with respect to third charges applied through connected bitline(s). The third charges may correspond to the sum of the first charges corresponding to first multi-bit data and the second charges corresponding to second multi-bit data. In an example embodiment, the ADC 120 may output a digital value corresponding to a result of adding the first multi-bit data to the second multi-bit data based on the voltage with respect to the third charges.

In an example embodiment, in a multiplication operation mode, the ADC 120 may sequentially receive a first voltage corresponding to the first charges and a second voltage corresponding to the second charges through connected bitline(s). The first charges may correspond to the first multi-bit data, and the second charges may correspond to the second multi-bit data. In an example embodiment, the ADC 120 may output a digital value corresponding to the first multi-bit data based on the first voltage. Then, the ADC 120 may output a digital value corresponding to a result of multiplying the first multi-bit data by the second multi-bit data based on the digital value corresponding to the first multi-bit and the second voltage.

In FIG. 1, only one ADC 120 is illustrated. However, this configuration is an example, and in some example embodiments, the number of ADCs 120 that may be provided in the memory device 100 is not limited thereto. For example, according to example embodiments, ADCs 120 may be provided in units of a number of bitlines. The number of bitlines may be predetermined.

The above-described example embodiments provide a ferroelectric memory device, capable of storing multi-bit data and performing various operation functions on the stored multi-bit data. Various analog operations related to the multi-bit data may be directly performed in a charge domain, so that operation time may be reduced.

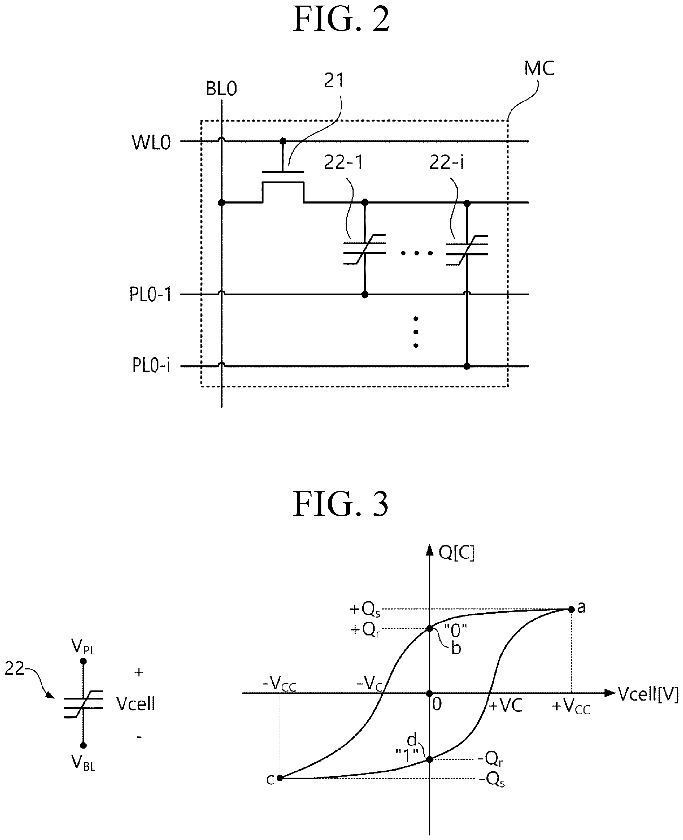

FIG. 2 is a diagram illustrating a configuration of a ferroelectric memory cell according to an example embodiment. Referring to FIG. 2, a ferroelectric memory cell MC may include an access transistor 21 and one or more ferroelectric capacitors 22-1 to 22-i. According to an example embodiment, the ferroelectric memory cell MC may include a single access transistor 21 and a single ferroelectric capacitor (for example, 22-1). Such a structure of the ferroelectric memory cell MC including the single access transistor 21 and the single ferroelectric capacitor 22-1 may be referred to as a 1T1C structure. According to an example embodiment, the ferroelectric memory cell MC may include a single access transistor 21 and a plurality of ferroelectric capacitors 22-1 to 22-i. Such a structure of the ferroelectric memory cell MC including the single access transistor 21 and the plurality of ferroelectric capacitors 22-1 to 22-i may be referred to as a 1TnC structure.

A control electrode (for example, a gate terminal of the access transistor 21) may be connected to a single wordline (WL0 in the example of FIG. 2), among wordlines WL0 to WLm of the memory cell array 110. A first electrode of the access transistor 21 may be connected to a single bitline (BL0 in the example of FIG. 2), among bitlines BL0 to BLn. A second electrode of the access transistor 21 may be commonly connected to one end of each of the one or more ferroelectric capacitors 22-1 to 22-i, as illustrated in FIG. 2.

Each of the one or more ferroelectric capacitors 22-1 to 22-i may have a first end commonly connected to the second electrode of the access transistor 21 and a second end connected to each of one or more plate lines PL0-1 to PL0-i. According to an example embodiment, the number of plate lines may correspond to the number of ferroelectric capacitors.

When a driving voltage is applied to the wordline WL0, the access transistor 21 may be turned on. Depending on the voltages applied to the bitline BL0 and each of the plate lines PL0-1 to PL0-I in the state in which the access transistor 21 is turned on, charges corresponding to data may be stored in the one or more ferroelectric capacitors 22-1 to 22-i or charges corresponding to the stored data may be discharged from the one or more ferroelectric capacitors 22-1 to 22-i.

Each of the ferroelectric capacitors 22-1 to 22-i may include a ferroelectric material. In an example embodiment, the ferroelectric material may include one of PZT, SBT, or BLT. Each of the ferroelectric capacitors 22-1 to 22-i may include at least one of, for example, hafnium oxide, hafnium zirconium oxide, zirconium oxide, barium strontium titanium oxide, barium titanium oxide, or lead zirconium titanium oxide. Here, hafnium zirconium oxide may be a material obtained by doping hafnium oxide with zirconium (Zr), or may be a compound of hafnium (Hf), zirconium (Zr), and oxide (O). In an example embodiment, each of the ferroelectric capacitors 22-1 to 22-i may further include a doping element doped in the above-mentioned material. The doping element may be aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), or tin (Sn).

FIG. 3 is a diagram illustrating a ferroelectric capacitor according to an example embodiment. FIG. 3 illustrates hysteresis loop characteristics of a ferroelectric capacitor 22. In the graph of FIG. 3, a horizontal axis represents a voltage Vcell across a ferroelectric capacitor 22, and a vertical axis represents total charges Q, for example, polarization, induced on a surface of the ferroelectric capacitor 22 according to the voltage Vcell. Qᵣ represents remnant charge, Qₛ represents saturation charge, and Vc represents coercive voltage. The coercive voltage refers to a magnitude of a voltage that causes total charges of the ferroelectric capacitor 22 to become zero. V_{PL} and V_{BL} illustrated across the ferroelectric capacitor 22 represent a voltage applied through the plate line PL and a voltage applied through the bitline BL, respectively.

Referring to FIG. 3, when Vcell increases from 0 in a positive direction, polarization may occur in the ferroelectric capacitor 22, and the total charges of the ferroelectric capacitor 22 may increase. When Vcell becomes +Vcc, the total charges may be +Qₛ (point "a"), and the total charges may no longer increase even if Vcell further increases. For example, the ferroelectric capacitor 22 may enter a saturated polarization state when Vcell is +Vcc or higher. Then, even when Vcell decreases to 0 again, a polarization direction may be maintained and the total charges may move along a curve to be non-zero +Qr (point "b").

When Vcell increases in a negative direction in the state in which the total charges are +Qr, the total charges may move along the curve from point "b," pass 0, and be - Qₛ (point "c"). Even when Vcell further increases in the negative direction than -Vcc, the total charges may no longer increase in the negative direction. For example, the ferroelectric capacitor 22 may enter a saturated polarization state even when Vcell is -Vcc or lower. The polarization direction of the ferroelectric material of the ferroelectric capacitor 22 may be opposite to the polarization at point "a." Then, even when Vcell becomes 0 again, the polarization direction may be maintained and the total charges may move along the curve to be non-zero -Qᵣ (point "d").

When Vcell increases from point "d" again in the positive direction, the total charges may move along the curve from point "d," pass 0, and change to point "a."

As described above, when an operating voltage such as +Vcc or -Vcc is applied across the ferroelectric capacitor 22, a polarization direction based on spontaneous polarization may be maintained in spite of removal of the applied voltage. Surface charges of the ferroelectric material, caused by spontaneous polarization, may not be naturally lost due to leakage, or the like. When a coercive voltage such as +Vc or -Vc is not applied to cause the polarization to become zero, the polarization direction may be maintained as it is.

According to an example embodiment, a state in which +Vcc is applied across the ferroelectric capacitor 22 and then removed, for example, a state in which total charges are +Qr (point "b"), may correspond to a state in which data "0" is stored in the ferroelectric capacitor 22, and a state in which -Vcc is applied across the ferroelectric capacitor 22 and then removed, for example, a state in which the total charges are -Qr (point "d"), may correspond to a state in which data "1" is stored in the ferroelectric capacitor 22.

However, example embodiments are not limited thereto. According to example embodiments, the state in which the total charges are +Qr (point "b") may correspond to the state in which data "1" is stored in the ferroelectric capacitor 22, and the state in which the total charges are -Qr (point "d") may correspond to the state in which data "0" is stored in the ferroelectric capacitor 22.

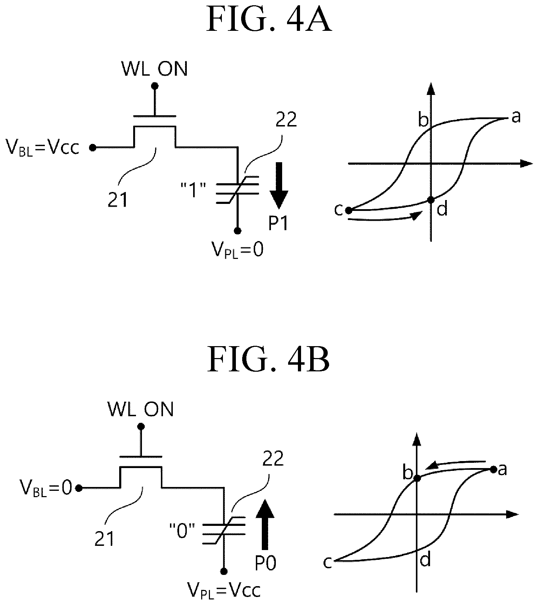

FIG. 4A and FIG. 4B are diagrams illustrating a program operation of a ferroelectric memory cell according to an example embodiment. FIG. 4A illustrates an operation of programming data "1," and FIG. 4B illustrates an operation of programming data "0."

In FIG. 4A and FIG. 4B, V_{PL} and V_{BL} represent a voltage of a plate line PL and a voltage of a bitline BL, respectively. It is noted that the graphs in FIGS. 4A and 4B are a simplified version of the hysteresis loop characteristic graph of FIG. 3. A direction of a voltage across a ferroelectric capacitor 22 in FIG. 4A and FIG. 4B is based on the direction of Vcell in FIG. 3.

Referring to FIG. 4A, when Vcc[V] is applied to the bitline BL and 0[V] is applied to the plate line PL in the state in which a driving voltage for turning on an access transistor 21 is applied to a wordline WL, the voltage Vcell across the ferroelectric capacitor 22 may become -Vcc[V]. Saturation polarization may occur in a direction P1 of the ferroelectric capacitor 22, and the total charges of the ferroelectric capacitor 22 may be disposed at point "c." Then, even when Vcell is removed, a polarization direction may be maintained and the total charges may move to point "d." Thus, data "1" may be programmed in the ferroelectric capacitor 22.

Referring to FIG. 4B, when 0[V] is applied to a bitline BL and Vcc[V] is applied to a plate line PL in the state in which a driving voltage for turning on an access transistor 21 is applied to a wordline WL, a voltage Vcell across a ferroelectric capacitor 22 may become +Vcc[V]. Saturation polarization may occur in a direction P0 direction of the ferroelectric capacitor 22, and total charges of the ferroelectric capacitor 22 may be disposed at point "a." Then, even when Vcell is removed, a polarization direction may be maintained and the total charges may move to point "b." Thus, data "0" may be programmed in the ferroelectric capacitor 22.

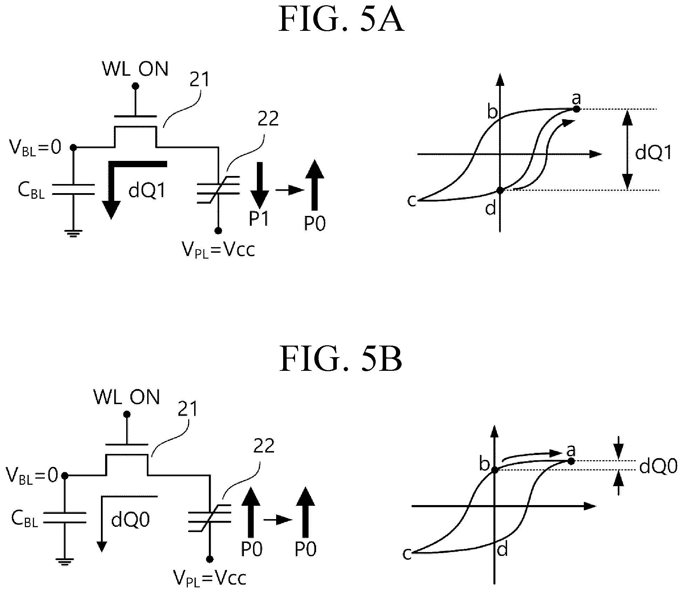

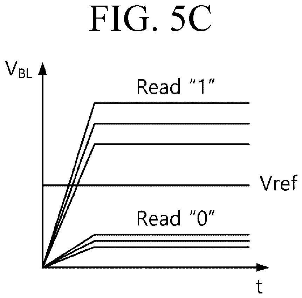

FIG. 5A to FIG. 5C are diagrams illustrating a read operation of a ferroelectric memory cell according to an example embodiment. FIG. 5A illustrates an operation of reading data "1", and FIG. 5B illustrates an operation of reading data "0." FIG. 5C illustrates a method of determining data based on a voltage applied to a bitline during a read operation.

In FIG. 5A and FIG. 5B, VPL and VBL represent a voltage of a plate line PL and a voltage of a bitline BL, respectively. It is noted that the graphs in FIGS. 5A and 5B are a simplified version of the hysteresis loop characteristic graph of FIG. 3. A direction of a voltage across a ferroelectric capacitor 22 in FIG. 5A and FIG. 5B is based on a direction of Vcell in FIG. 3.

According to an example embodiment, the same voltage as a voltage for programming data "0" may be applied across the ferroelectric capacitor 22 during a read operation. For example, a bitline BL may be precharged to 0[V] and Vcc[V] may be applied to the plate line PL during the read operation. In an example embodiment, a polarization direction of the ferroelectric capacitor 22 may be switched or maintained as it is, depending on the type of stored data. When the polarization direction is switched, a relatively large amount of positive charges may be discharged from the ferroelectric capacitor 22 to the bitline BL. When the polarization direction is maintained, a relatively small amount of positive charge may be discharged from the ferroelectric capacitor 22 to the bitline BL. The type of data may be identified based on a difference in charges discharged to the bitline BL by a sense amplifier, not illustrated in FIGS. 5A and 5B.

A detailed description will now be provided with referenced to FIG. 5A. When data "1" is stored, total charges of the ferroelectric capacitor 22 may be disposed at point "d" and the polarization direction may be P1. When a driving voltage for turning on an access transistor 21 is applied to a wordline WL, the bitline BL may be precharged to 0[V], Vcc[V] may be applied to a plate line PL, the polarization direction may be switched to P0, and the total charges of the ferroelectric capacitor 22 may move from point "d" to point "a." Charges dQ1 corresponding to a difference between point "d" and point "a" may be discharged to the bitline BL through the access transistor 21.

Referring to FIG. 5B, when data "0" is stored, total charges of the ferroelectric capacitor 22 may be disposed at point "b" and the polarization direction may be P0. When a driving voltage for turning on the access transistor 21 may be applied to a wordline WL, the bitline BL may be precharged to 0[V], Vcc[V] may be applied to a plate line PL, the total charges of the ferroelectric capacitor 22 may move from point "b" to point "a." The polarization direction may be maintained as it is, and charges dQ0 corresponding to a difference between point "b" and point "a" may be discharged to the bitline BL through the access transistor 21.

A capacitance component is present in the bitline BL, so that when charges are discharged to the bitline BL, a bitline voltage V_{BL} corresponding to the discharged charges may be applied to the bitline BL. In FIGS. 5A and 5C, CBL represents a total capacitance component of the bitline BL. The magnitude of the bitline voltage VBL may be proportional to the magnitude of the charges discharged to the bitline BL. Accordingly, a sense amplifier, not illustrated in FIGS. 5A and 5B, may compare the bitline voltage VBL with a reference voltage Vref to determine the type of data stored in the ferroelectric capacitor 22.

For example, referring to FIG. 5A to FIG. 5C, when data "1" is stored in the ferroelectric capacitor 22, the relatively large amount of charges dQ1 may be discharged to the bitline BL, so that a voltage higher than the reference voltage Vref may be applied to the bitline BL. Accordingly, the sense amplifier may detect data "1." When data "0" is stored in the ferroelectric capacitor 22, the relatively small amount of charges dQ0 may be discharged to the bitline BL, so that a voltage lower than the reference voltage Vref may be applied to the bitline BL. Accordingly, the sense amplifier may detect data "0."

When data "1" is read, a bitline voltage VBL corresponding to data "1" is applied to the bitline BL. Therefore, data "1" may be programmed in the ferroelectric capacitor 22a by decreasing the voltage of the plate line PL to 0[V]. Such an operation may be referred to as a write back operation.

While the case in which data is programmed in or read from a single ferroelectric capacitor 22 has been described with reference to FIGS. 4A to 5C, it should be noted that a program or read operation of data may also be performed in the above-described manner even for a configuration in which each of the plurality of ferroelectric capacitors in a ferroelectric memory cell have a 1TnC structure.

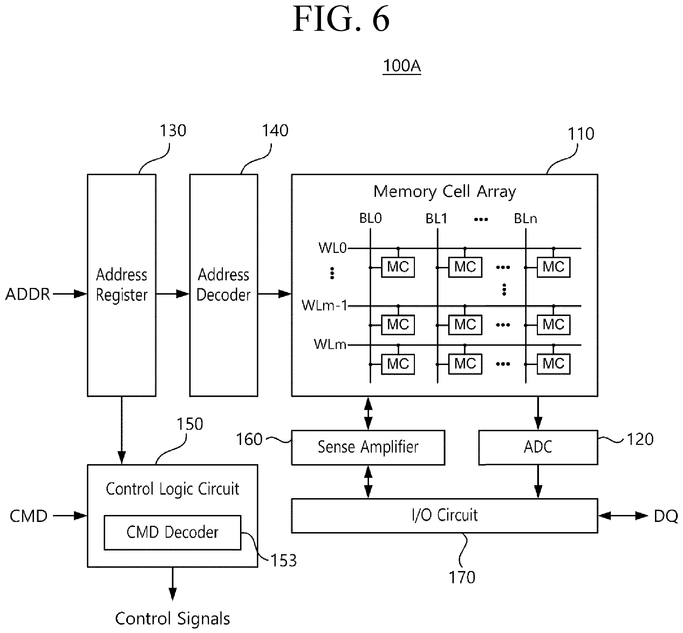

FIG. 6 is a block diagram of a memory device according to an example embodiment. A memory device 100A of FIG. 6 may be an example of implementing the memory device 100 of FIG. 1, but example embodiments are not limited thereto. Referring to FIG. 6, the memory device 100A may include a memory cell array 110, an ADC 120, an address register 130, an address decoder 140, a control logic circuit 150, a sense amplifier 160, and an input/output (I/O) circuit 170.

The memory device 100 may input and output data DQ in response to a command CMD and an address ADDR received from an external device (for example, a central processing unit (CPU) or a memory controller).

The memory cell array 110 and the ferroelectric memory cells MC included in the memory cell array 110 have been described in detail with reference to FIG. 1 to FIG. 5C, and redundant descriptions thereof are omitted to avoid repetition.

The address register 130 may receive an address ADDR from an external device and transmit at least a portion of the received address ADDR to the address decoder 140 and the control logic circuit 150. The address ADDR may include a wordline address for selecting a portion of wordlines WL0 to WLm connected to the memory cell array 110, a bitline address for selecting a portion of bitlines BL0 to BLn connected to the memory cell array 110, and a plate line address for selecting a portion of plate lines PLs connected to the memory cell array 110.

The address decoder 140 may select a memory cell MC corresponding to the address ADDR, among multiple memory cells MCs, and may drive the selected memory cell. For example, the address decoder 140 may select a wordline WL, a bitline BL, and a plate line PL of the memory cell MC to be accessed in response to the received address ADDR, and may drive the memory cell MC corresponding to the selected wordline WL, bitline BL, and plate line PL. To this end, in an example embodiment, the address decoder 140 may include a wordline decoder, a bitline decoder, and a plate line decoder.

The wordline decoder may decode a wordline address and drive a wordline corresponding to the decoded wordline address. The bitline decoder may decode a bitline address and drive a bitline corresponding to the decoded bitline address. The plate line decoder may decode a plate line address and drive a plate line corresponding to the decoded plate line address.

The control logic circuit 150 may control an operation of the memory device 100A. For example, the control logic circuit 150 may generate various control signals such that the memory device 100A performs operations such as a program operation, a read operation, an addition operation, a multiplication operation, a precharge operation, or a write back operation. To this end, the control logic circuit 150 may include a command (CMD) decoder 153 decoding commands CMD received from the external device.

The sense amplifier 160 may detect data stored in a memory cell MC. For example, the sense amplifier 160 may detect data stored in a memory cell MC by comparing the bitline voltage V_{BL}, corresponding to charges discharged from the memory cell MC to a bitline BL, with a reference voltage Vref. The detected data may be transmitted to the input/output circuit 170, and may be output to the outside of the memory device 100A. In an example embodiment, the sense amplifier 160 may transmit program data, received from the outside through the input/output circuit 170, to the memory cell array 110. In an example embodiment, the sense amplifier 160 may be a bitline sense amplifier.

The ADC 120 may be selectively connected to the bitlines BL0 to BLn and output a digital value, corresponding to charges applied through at least one of the connected bitlines, to the input/output circuit 170.

In an example embodiment, the ADC 120 may receive charges corresponding to multiple multi-bit data through connected bitlines in an addition operation mode. The ADC 120 may output a digital value corresponding to the sum of a plurality of pieces of multi-bit data.

In an example embodiment, in the addition operation mode, a first voltage corresponding to first charges may be applied to a first bitline and a second voltage corresponding to second charges may be applied to a second bitline according to a read operation. The first charges may correspond to first multi-bit data stored in a portion of ferroelectric memory cells connected to the first bitline, and the second charges may correspond to second multi-bit data stored in a portion of ferroelectric memory cells connected to the second bitline. The ADC 120 may be simultaneously connected to both the first bitline and the second bitline under the control of the control logic circuit 150. Accordingly, a third voltage, the sum of the first voltage and the second voltage, may be applied to the ADC 120. The third voltage may be a voltage corresponding to third charges, where the third charges are the sum of the first charges and the second charges. The ADC 120 may output a digital value based on a ramp voltage and the third voltage, and the output digital value may correspond to the sum of the first multi-bit data and the second multi-bit data.

In an example embodiment, the ADC 120 may sequentially receive charges corresponding to each of the plurality of pieces of multi-bit data through the connected bitlines in a multiplication operation mode. The ADC 120 may output a digital value corresponding to a multiplication result of the plurality of pieces of multi-bit data.

In an example embodiment, in the multiplication operation mode, a first voltage corresponding to first charges may be applied to a first bitline and a second voltage corresponding to second charges may be applied to a second bitline according to a read operation. The first charges may correspond to first multi-bit data stored in a portion of ferroelectric memory cells connected to the first bitline, and the second charges may correspond to second multi-bit data stored in a portion of ferroelectric memory cells connected to the second bitline.

The ADC 120 may be connected to the first bitline under the control of the control logic circuit 150, and the first voltage may be applied to the ADC 120. Accordingly, the ADC 120 may output a digital value corresponding to first multi-bit data based on the first voltage. As will be described later, a ramp generator, not illustrated in FIG. 6, may adjust a slope of the ramp voltage based on the digital value corresponding to the first multi-bit data.

The ADC 120 may be connected to the second bitline under the control of the control logic circuit 150. Accordingly, the second voltage may be applied to the ADC 120. The ADC 120 may output a digital value based on the ramp voltage having the slope adjusted based on the digital value corresponding to the first multi-bit data and output the digital value based on the second voltage. The output digital value may correspond to a multiplication result of the first multi-bit data and the second multi-bit data.

The input/output circuit 170 may receive data DQ to be programmed in the memory cells MCs from the outside and transmit the received data DQ to the memory cell array 110 through the sense amplifier 160. To this end, the input/output circuit 170 may include a write path. The write path may include a write driver.

The input/output circuit 170 may include a read-out path for outputting data, detected by the sense amplifier 160 or a calculation result output from the ADC 120, to the outside. The read-out path may include a data sense amplifier.

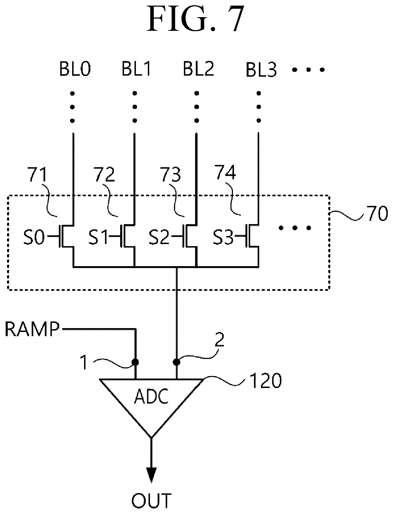

FIG. 7 is a diagram illustrating selective connection of an ADC according to an example embodiment. Referring to FIG. 7, the memory device 100 or 100A may include a switching circuit 70 disposed between bitlines BL0 to BLn of a memory cell array 110 and the ADC 120.

The ADC 120 may include a first input terminal 1 that is configured to receive a ramp voltage RAMP, and a second input terminal 2 configured to receive a voltage corresponding to charges applied through selectively connected bitlines. In an example embodiment, the ADC 120 may be a single-slope ADC, but example embodiments are not limited thereto.

The switching circuit 70 may include a plurality of switching elements 71, 72, 73, 74.... Each of the plurality of switching elements 71, 72, 73, 74... may have a first end connected to a respective bitline of the bitlines BL0 to BL3, etc., and a second end connected to a second input terminal 2 of the ADC 120. Accordingly, the ADC 120 may be selectively connected to at least one of the bitlines BL0 to BLn in an operation mode based on the bitline select signals S0, S1, S2, S3... applied from the control logic circuit 150. It is noted that FIG. 7 illustrates an example with four bitlines BL0 to BL3, four switching elements 71 to 74, and four bitline select signals S0 to S3 are provided. However, this configuration is only an example and the number of bitlines, switching elements, and bitline select signals may vary.

FIG. 7 illustrates an example embodiment in which a single ADC 120 is selectively connected to the bitlines BL0 to BLn, but example embodiments are not limited thereto. For example, the memory device 100 or 100A may include a plurality of ADCs 120 and may be selectively connected to the bitlines BL0 to BLn through the plurality of ADCs 120. In an example embodiment, the bitlines BL0 to BLn of the memory cell array 110 may be divided into a plurality of groups, and each of the ADCs 120 may be selectively connected to a predetermined number of bitlines included in a corresponding group.

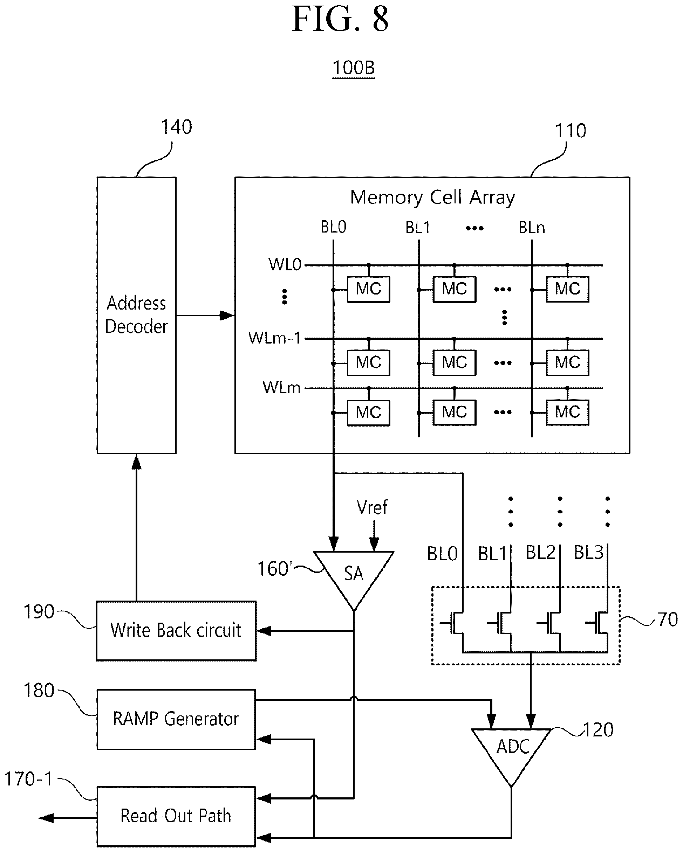

FIG. 8 is a block diagram of a memory device according to an example embodiment. The memory device 100B of FIG. 8 may be an example of implementing the memory device 100 or 100A of FIG. 1 and FIG. 7, but example embodiments are not limited thereto.

Referring to FIG. 8, a memory device 100B may include the memory cell array 110, the address decoder 140, a sense amplifier 160', the ADC 120, the switching circuit 70, a read-out path 170-1, a ramp generator 180, and a write back circuit 190. For the description of FIG. 8, redundant descriptions are omitted to avoid repetition.

The ramp generator 180 may generate a ramp voltage having a magnitude varying depending on time. For example, the ramp generator 180 may generate a first ramp voltage having a first slope. The ramp generator 180 may generate a second ramp voltage having a second slope, different from the first slope, based on a digital value output from the ADC 120. The ramp generator 180 may provide the generated first or second ramp voltage to a first input terminal 1 of the ADC 120.

The sense amplifier 160' may compare a voltage corresponding to charges discharged to a bitline BL and a reference voltage Vref to read data stored in a ferroelectric memory cell MC. While only one sense amplifier 160' connected to a bitline BL0 is illustrated in FIG. 8, in some example embodiments, the sense amplifier 160' may be provided for each bitline and may be connected to a corresponding bitline. In other words, in some example embodiments, sense amplifiers may be connected to bitlines in a one-to-one relationship.

As described above, during a read operation, a voltage equal to a voltage for programming data "0" may be applied across the ferroelectric capacitor 22. Accordingly, when a read operation is performed on a ferroelectric capacitor in which data "1" is stored, the data may be lost. For example, a read operation on a ferroelectric memory cell may be data-destructive.

The write back circuit 190 may reprogram data, read from a ferroelectric memory cell MC through a sense amplifier 160', in the ferroelectric memory cell MC when data stored in the ferroelectric memory cell MC is read through the sense amplifier 160'. For example, when data "1" is read from a ferroelectric memory cell MC corresponding to a specific address ADDR, the write back circuit 190 may control the address decoder 140 such that data "1" is re-stored in the corresponding ferroelectric memory cell. Accordingly, the data stored in the memory cell array 110 may be retained even after a read operation.

In an example embodiment, the memory device 100B may store and read single-bit data. The single-bit data refers to 1-bit data with a single digit, and may have a value of "0" or "1."

For example, during a single-bit program operation, the address decoder 140 may drive a wordline WL, a bitline BL, and a plate line PL connected to a ferroelectric memory cell MC corresponding to an address ADDR to store single-bit data in the ferroelectric memory cell MC. Accordingly, single-bit data may be programmed (or stored) in the ferroelectric memory cell MC corresponding to the address ADDR. When the ferroelectric memory cell MC has a 1T1C structure, one piece of single-bit data may be stored in a single ferroelectric memory cell MC. In an example embodiment, when the ferroelectric memory cell MC has a 1TnC structure, a plurality of pieces of single-bit data may be stored in a single ferroelectric memory cell MC. For example, when four ferroelectric capacitors are included in the ferroelectric memory cell MC, four pieces of single-bit data may be stored in a single ferroelectric memory cell MC.

During a single-bit read operation, the address decoder 140 may drive a wordline WL, a bitline BL, and a plate line PL connected to a ferroelectric memory cell MC corresponding to an address ADDR to read one piece of single-bit data stored in the ferroelectric memory cell MC. Charges corresponding to the one piece of single-bit data may be discharged from the ferroelectric memory cell MC corresponding to the address ADDR to the bitline BL. This operation is equivalently applied to both 1T1C and ITnC structures. When a bitline voltage V_{BL} corresponding to the discharged charges is applied to the sense amplifier 160', the sense amplifier 160' may compare the applied bitline voltage V_{BL} with the reference voltage Vref to read single-bit data. The read single-bit data may be transmitted to an external device through the read-out path 170-1. When the read data is "1," the write back circuit 190 may reprogram data "1" in the corresponding ferroelectric memory cell MC or the corresponding ferroelectric capacitor.

According to an example embodiment, the memory device 100B may store multi-bit data. The multi-bit data is binary data including two or more bits. A plurality of bits, included in one piece of multi-bit data, have different digit values.

For example, 3-bit data includes 3 binary bits and has 3 different digit values such as 2², 2¹, and 2⁰. Therefore, a digit value of each bit of the multi-bit data should be represented through the memory cell array 110 to store the multi-bit data in the memory cell array 110. In the case of the ferroelectric memory cell MC, a digit value may be represented by charges stored in the ferroelectric memory cell MC.

In an exemplary embodiment, each ferroelectric memory cell MC in the memory cell array 110 may have a 1TnC structure. A plurality of ferroelectric capacitors included in each ferroelectric memory cell MC may have different capacities and correspond to a plurality of digits of multi-bit data, respectively.

For example, a ferroelectric memory cell MC having a 1T3C structure may be provided. The ferroelectric memory cell MC may include a first ferroelectric capacitor having capacitance of a[F], a second ferroelectric capacitor having capacitance of 2a[F], and a third ferroelectric capacitor having capacitance of 4a[F]. The first ferroelectric capacitor may store a bit value of a 2⁰ digit of the 3-bit data, the second ferroelectric capacitor may store a bit value of a 2¹ digit of the 3-bit data, and the third ferroelectric capacitor may store a bit value of a 2² digit of the 3-bit data. As described above, digit values of the multi-bit data may be represented by a difference in capacitance of the ferroelectric capacitors included in the ferroelectric memory cell MC.

In an example embodiment, the memory cell array 110 may include a plurality of types of ferroelectric memory cells, respectively corresponding to a plurality of digits of multi-bit data. For example, the memory cell array 110 may include ferroelectric memory cells corresponding to a 2⁰ digit of the 3-bit data, ferroelectric memory cells corresponding to a 2¹ digit of the 3-bit data, and ferroelectric memory cells corresponding to a 2² digit of the 3-bit data.

Each of the ferroelectric memory cells may have a 1TnC structure and may include a same number of ferroelectric capacitors having the same capacitance. In an example embodiment, each of the ferroelectric memory cells may be controlled by a different number of plate lines depending on a corresponding digit. For example, each of the ferroelectric memory cells may include 4 ferroelectric capacitors, respectively connected to 4 different plate lines. A ferroelectric memory cell corresponding to a 2⁰ digit may be controlled by one plate line, a ferroelectric memory cell corresponding to a 2¹ digit may be controlled by two plate lines, and a ferroelectric memory cell corresponding to a 2² digit may be controlled by four plate lines.

The ferroelectric memory cell corresponding to the 2⁰ digit may store a bit value of the 2⁰ digit of the 3-bit data using one ferroelectric capacitor, the ferroelectric memory cell corresponding to the 2¹ digit may store a bit value of the 2¹ digit of the 3-bit data using two ferroelectric capacitors, and the ferroelectric memory cell corresponding to the 2² digit may store a bit value of the 2² digit of the 3-bit data using four ferroelectric capacitors. As described above, digit values of multi-bit data may be represented by controlling a plurality of ferroelectric capacitors, included in a ferroelectric memory cell MC, through different number of plate lines depending on corresponding digit values.

According to an example embodiment, the memory device 100B may perform a calculation operation on a plurality of pieces of multi-bit data.

For example, in an addition operation mode, the address decoder 140 may select and drive a portion of the plurality of ferroelectric memory cells MCs. Accordingly, first charges corresponding to first multi-bit data and second charges corresponding to second multi-bit data may be discharged to bitline(s). The control logic circuit 150 may control the switching circuit 70 through a bitline select signal to connect the ADC 120 and the bitline(s) to which the charges are discharged. When a voltage corresponding to third charges, where the third charges are the sum of the first charges and the second charges, is applied through the connected bitlines, the ADC 120 may output a digital value corresponding to an addition operation result of the first multi-bit data and the second multi-bit data based on a ramp voltage and a voltage corresponding to the third charges.

For example, in a multiplication operation mode, the address decoder 140 may drive a portion of the plurality of ferroelectric memory cells MCs to discharge the first charges corresponding to the first multi-bit data to a corresponding bitline. The control logic circuit 150 may control the switching circuit 70 through the bitline select signal to connect the ADC 120 and the bitline to which the first charges are discharged. When a voltage corresponding to the first charges is applied through the connected bitline, the ADC 120 may output a digital value corresponding to first multi-bit data based on a ramp voltage and a voltage corresponding to the first charges. The ramp generator 180 may adjust a slope of the ramp voltage based on the digital value corresponding to the first multi-bit data. Then, the address decoder 140 may drive a portion of the plurality of ferroelectric memory cells MCs to discharge the second charges corresponding to the second multi-bit data to a corresponding bitline. The control logic circuit 150 may control the switching circuit 70 through a bitline select signal to connect the ADC 120 and the bitline to which the second charges are discharged. When a voltage corresponding to the second charges is applied through the connected bitline, the ADC 120 may output a digital value corresponding to the multiplication operation result of the first multi-bit data and the second multi-bit data based on the ramp voltage having the adjusted slope and a voltage corresponding to the second charges.

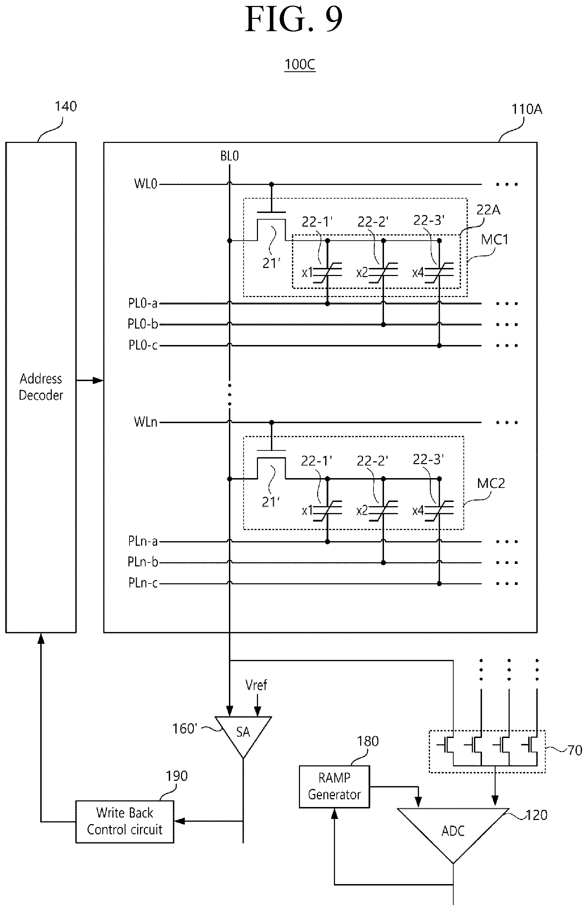

Hereinafter, various embodiments in which multi-bit data is stored in ferroelectric memory cells will be described with reference to FIGS. 9 to FIGS. 12.

FIG. 9 is a block diagram of a memory device according to an example embodiment. The memory device 100C of FIG. 9 may be an example of implementing the above-described memory devices 100, 100A, and 100B, but example embodiments are not limited thereto. For the description of FIG. 9, redundant descriptions are omitted to avoid repetition.

Referring to FIG. 9, a memory cell array 110A may include a plurality of ferroelectric memory cells MC1, MC2.... Each of the plurality of ferroelectric memory cells MC1, MC2... may have a same structure.

For example, a ferroelectric memory cell MC1 may include an access transistor 21' and a plurality of ferroelectric capacitors 22A. The plurality of ferroelectric capacitors 22A may include a first ferroelectric capacitor 22-1', a second ferroelectric capacitor 22-2', and a third ferroelectric capacitor 22-3'.

A control electrode (for example, a gate terminal) of the access transistor 21' may be connected to a wordline WL0. A first electrode of the access transistor 21' may be connected to a bitline BL0. A second electrode of the access transistor 21' may be commonly connected to a first end of each of the first to third ferroelectric capacitors 22-1', 22-2', and 22-3'. The second end of the first to third ferroelectric capacitors 22-1', 22-2', and 22-3' may be connected respectively to first to third plate lines PLO-a, PL0-b, and PL0-c. For example, the second end of the first ferroelectric capacitor 22-1' may be connected to the first plate line PL0-a, and the second end of the second ferroelectric capacitor 22-2' may be connected to the second plate line PL0-b, and so on.

The first to third ferroelectric capacitors 22-1', 22-2', and 22-3' may have different capacitances. For example, the capacitance of the second ferroelectric capacitor 22-2' may be twice the capacitance of the first ferroelectric capacitor 22-1'., and the capacitance of the third ferroelectric capacitor 22-3' may be four times the capacitance of the first ferroelectric capacitor 22-1', as indicated by x1, x2, and x4 respectively in FIG. 9.

In an example embodiment, 3-bit data may be stored in the ferroelectric memory cell MC1 based on the difference in capacitance of the first to third ferroelectric capacitors 22-1', 22-2', and 22-3'. For example, a bit value of a 2⁰ digit of the 3-bit data may be stored in the first ferroelectric capacitor 22-1', a bit value of a 2¹ digit may be stored in the second ferroelectric capacitor 22-2', and a bit value of a 2³ digit may be stored in the third ferroelectric capacitor 22-3'.

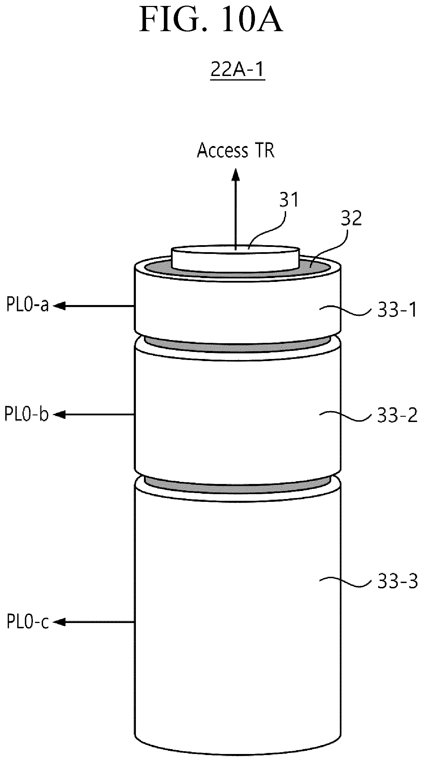

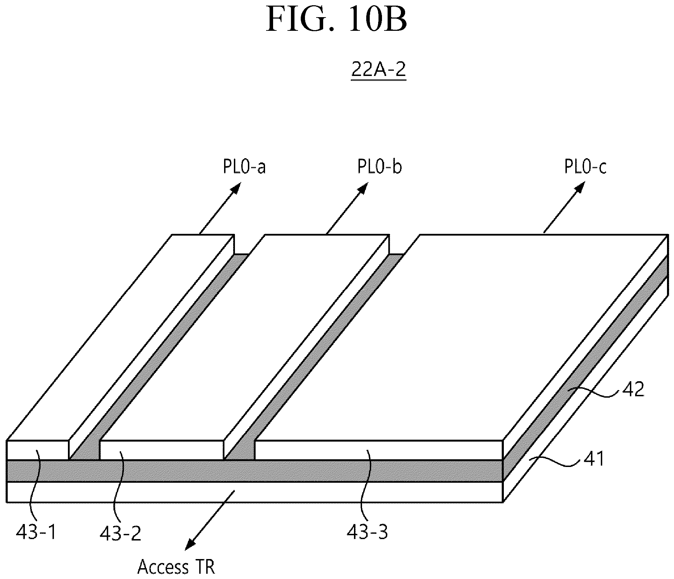

FIGS. 10A and 10B are diagrams illustrating examples of implementing the plurality of ferroelectric capacitors 22A of FIG. 9. FIG. 10A illustrates an example of a cylindrical structure, and FIG. 10b illustrates an example of a planar structure.

Referring to FIG. 10A, a plurality of ferroelectric capacitors 22A-1 may include a cylindrical inner electrode 31, a ferroelectric layer 32 surrounding an outer peripheral surface of the inner electrode 31, and first to third outer electrodes 33-1, 33-2, and 33-3 surrounding the outer peripheral surface of the ferroelectric layer 32.

The first to third outer electrodes 33-1, 33-2, and 33-3 may correspond to first to third ferroelectric capacitors 22-1', 22-2', and 22-3', respectively. For example, the second end of the first to third ferroelectric capacitors 22-1', 22-2', and 22-3' are connected to respective ones of the first to third plate lines PLO-a, PL0-b, and PL0-c, so that the first to third outer electrodes 33-1, 33-2, and 33-3 may be electrically separated from each other and may be connected to the first to third plate lines PLO-a, PL0-b, and PL0-c, respectively. By taking the capacitances of the first to third ferroelectric capacitors 22-1', 22-2', and 22-3' into account, a height of the second outer electrode 33-2 in an axial direction may be twice a height of the first outer electrode 33-1 and a height of the third outer electrode 33-3 may be four times a height of the first outer electrode 33-1.

The first end of each of the first to third ferroelectric capacitors 22-1', 22-2', and 22-3' is commonly connected to the second electrode of the access transistor 21', so that the inner electrode 31 commonly coupled to the first to third outer electrodes 33-1, 33-2, and 33-3 may be connected to a second electrode of the access transistor 21'.

Referring to FIG. 10B, a plurality of ferroelectric capacitors 22A-2 may include a first planar electrode 41, a ferroelectric layer 42 stacked on the first planar electrode 41, and a plurality of second planar electrodes 43-1, 43-2, and 43-3 stacked on the ferroelectric layer 42. The plurality of second planar electrodes 43-1, 43-2, and 43-3 may include a 2-1-th planar electrode 43-1, a 2-2-th planar electrode 43-2, and a 2-3-th planar electrode 43-3.

The plurality of second planar electrodes 43-1, 43-2, and 43-3 may correspond to first to third ferroelectric capacitors 22-1', 22-2', and 22-3', respectively. For example, the second end of the first to third ferroelectric capacitors 22-1', 22-2', and 22-3' is connected to respective ones first to third plate lines PLO-a, PL0-b, and PL0-c, so that the plurality of second planar electrodes 43-1, 43-2, and 43-3 may be electrically separated from each other and may be connected to respective ones of the first to third plate lines PLO-a, PL0-b, and PL0-c. By taking the capacitances of the first to third ferroelectric capacitors 22-1', 22-2', and 22-3' into consideration, a width of the 2-2-th planar electrode 43-2 may be twice a width of the 2-1-th planar electrode 43-1 and a width of the 2-3-th planar electrode 43-3 may be four times a width of the 2-1-th planar electrode 43-1.

The first end of each of the first to third ferroelectric capacitors 22-1', 22-2', and 22-3' is commonly connected to the second electrode of the access transistor 21', the first planar electrode 41 commonly coupled to the plurality of second planar electrodes 43-1, 43-2, and 43-3 may be connected to a second electrode of the access transistor 21'.

In FIGS. 9 to FIGS. 10B, descriptions have been provided for an example in which a single ferroelectric memory cell includes three ferroelectric capacitors having different capacities to store 3-bit data. However, example embodiments are not limited thereto. According to example embodiments, a ferroelectric memory cell may include two ferroelectric capacitors having different capacitances to store 2-bit data. In some example embodiments, a ferroelectric memory cell may include four or more ferroelectric capacitors to store 4 or more bits of data.

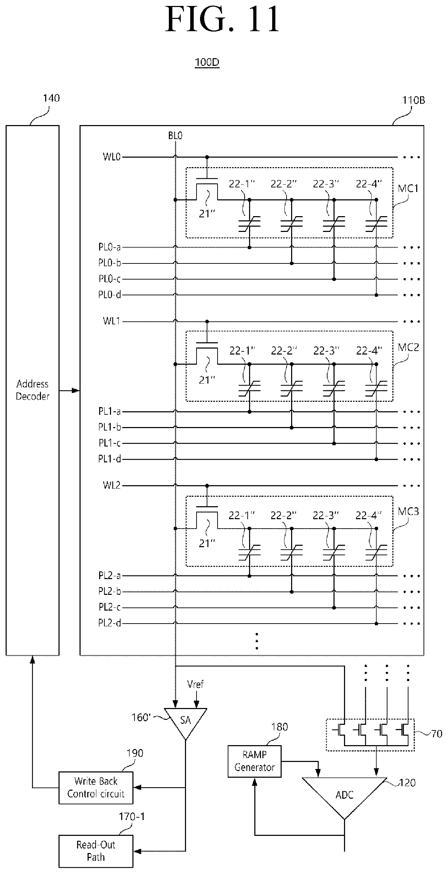

FIG. 11 is a block diagram of a memory device according to an example embodiment. A memory device 100D of FIG. 11 may be an example of implementing the above-described memory devices 100, 100A, and 100B, but example embodiments not limited thereto. For the description of FIG. 11, redundant descriptions are omitted to avoid repetition.

Referring to FIG. 11, a memory cell array 110B may include a plurality of ferroelectric memory cells MC1, MC2.... Each of the plurality of ferroelectric memory cells MC1, MC2... may have a same structure.

For example, a ferroelectric memory cell MC1 may include an access transistor 21" and first to fourth ferroelectric capacitors 22-1", 22-2", 22-3", and 22-4".

A control electrode (for example, a gate terminal) of the access transistor 21" may be connected to the wordline WL0. A first electrode of the access transistor 21" may be connected to the bitline BL0. A second electrode of the access transistor 21" may be commonly connected to a first end of each of the first to fourth ferroelectric capacitors 22-1", 22-2", 22-3", and 22-4". A second end of the first to fourth ferroelectric capacitors 22-1", 22-2", 22-3", and 22-4" may be connected to respective ones of the first to fourth plate lines PLO-a, PL0-b, PL0-c, and PL0-d. Capacitances of the first to fourth ferroelectric capacitors 22-1", 22-2", 22-3", and 22-4" may be the same.

The memory cell array 110B may include a plurality of different types of ferroelectric memory cells, respectively corresponding to a plurality of different digits of multi-bit data. For example, the memory cell array 110B may include a ferroelectric memory cell MC1 corresponding to a 2⁰ digit of 3-bit data, a ferroelectric memory cell MC2 corresponding to a 2¹ digit of the 3-bit data, and a ferroelectric memory cell MC3 corresponding to a 2² digit of the 3-bit data. Each of the ferroelectric memory cell MC1, MC2, and MC3 may be controlled by a different number of plate lines depending on a corresponding digit. For example, the ferroelectric memory cell MC1 corresponding to the 2⁰ digit may be controlled through one plate line (for example, PL0-a), the ferroelectric memory cell MC2 corresponding to the 2¹ digit may be controlled through two plate lines (for example, PL1-a and PL1-b), and the ferroelectric memory cell MC3 corresponding to the 2² digit may be controlled through (for example, four plate lines PL2-a, PL2-b, PL2-c, and PL2-d).

In an example embodiment, the ferroelectric memory cell MC1 may store a bit value of the 2⁰ digit of the 3-bit data using one ferroelectric capacitor 22-1" connected to PL0-a, the ferroelectric memory cell MC2 may store a bit value of the 2¹ digit of the 3-bit data using two ferroelectric capacitors 22-1" and 22-2", respectively connected to PL1-a and PL1-b, and the ferroelectric memory cell MC3 may store a bit value of the 2² digit of the 3-bit data using four ferroelectric capacitors 22-1", 22-2", 22-3", and 22-4", respectively connected to PL2-a, PL2-b, PL2-c, and PL2-d.

In FIG. 11, a description has been provided for an example in which 3-bit data is stored using three types of ferroelectric memory cells controlled by a different number of plate lines. However, example embodiments are not limited thereto. According to example embodiments, 2-bit data may be stored using two types of ferroelectric memory cells controlled by a different number of plate lines, or 4 or more bits of data may be stored using four or more types of ferroelectric memory cells controlled by a different number of plate lines.

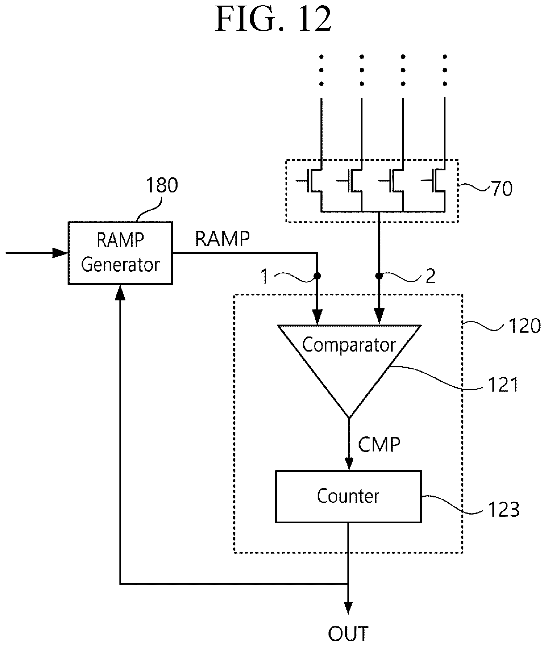

Hereinafter, a calculation operation on multi-bit data stored in ferroelectric memory cells will be described with reference to FIGS. 12 to FIGS. 14B.

FIG. 12 is a diagram illustrating the configuration and operation of an ADC according to an example embodiment. Referring to FIG. 12, an ADC 120 may include a comparator 121 and a counter 123. The comparator 121 may compare a ramp voltage RAMP, provided from a ramp generator 180, with a voltage, corresponding to charges applied through bitline(s) connected to the ADC 120, to output a comparison signal CMP. The counter 123 may perform a counting operation based on the comparison signal CMP output from the comparator 121 and output a digital value OUT corresponding to the number of counted clocks. The digital value OUT may correspond to the charges applied through the bitline(s) connected to the ADC 120.

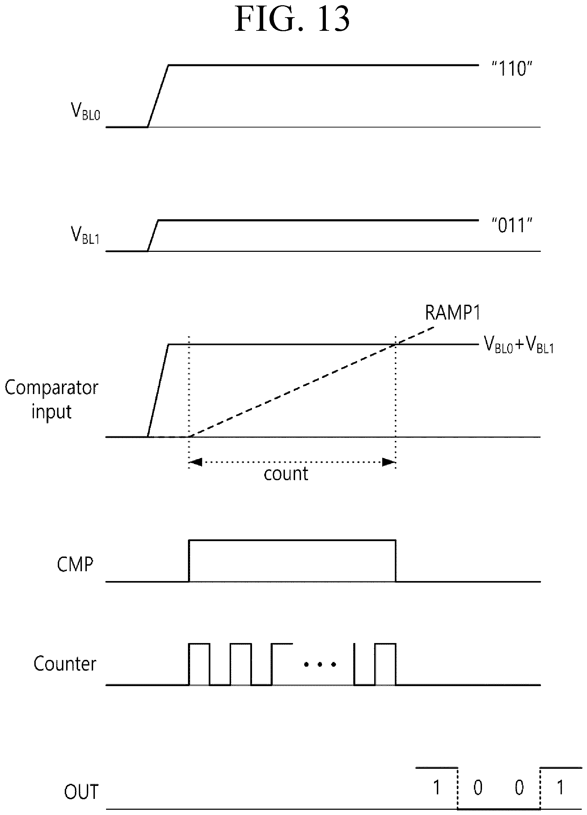

FIG. 13 is a diagram illustrating an addition operation according to an example embodiment. In FIG. 13, a description will be provided for an example in which 3-bit data "110" is stored in ferroelectric memory cell(s) connected to a bitline BL0, and 3-bit data "011" is stored in ferroelectric memory cell(s) connected to a bitline BL1.

Referring to FIGS. 12 and 13, in the addition operation mode, first charges corresponding to the 3-bit data "110" may be discharged to the bitline BL0 and second charges corresponding to the 3-bit data "011" may be discharged to the bitline BL1 depending on a read operation. Accordingly, a first voltage V_{BL0} corresponding to the first charges may be applied to the bitline BL0, and a second voltage V_{BL1} corresponding to the second charges may be applied to the bitline BL1.

When the bitline BL0 and the bitline BL1 are connected to the ADC 120 under the control of the control logic circuit 150, a ramp voltage RAMP1 having a first slope may be applied to a first input terminal 1 of the ADC 120 and a voltage corresponding to third charges, where the third charges are the sum of the first charges and the second charges, for example, a third voltage V_{BL0}+V_{BL1}, the sum of the first voltage V_{BL0} and the second voltage V_{BL1}, may be applied to a second input terminal 2.

Accordingly, the comparator 121 may compare the ramp voltage RAMP1 with the third voltage V_{BL0}+V_{BL1} to output a comparison signal CMP, and the counter 123 may perform a counting operation and then output a digital value OUT corresponding to the number of counted clocks. The output digital value may be "1001" corresponding to an addition operation result of "110" and "011."

Unlike the above-described example, 3-bit data "110" may be stored in a portion of the ferroelectric memory cell(s) s connected to the bitline BL0, and 3-bit data "011" may be stored in another portion of the ferroelectric memory cell(s) s connected to the bitline BL0.

In an example embodiment, the third charges, the sum of the first charges and the second charges, may be discharged to the bitline BL0 and the third voltage V_{BL0}+V_{BL1} may be applied to the bitline BL0 depending on the read operation. When the bitline BL0 is connected to the ADC 120 under the control of the control logic circuit 150, a ramp voltage RAMP1 may be applied to the first input terminal 1 of the ADC 120, the third voltage V_{BL0}+V_{BL1} may be applied to the second input terminal 2 of the ADC 120, and the ADC 120 may output a digital value "1001" corresponding to the addition operation result of "110" and "011".

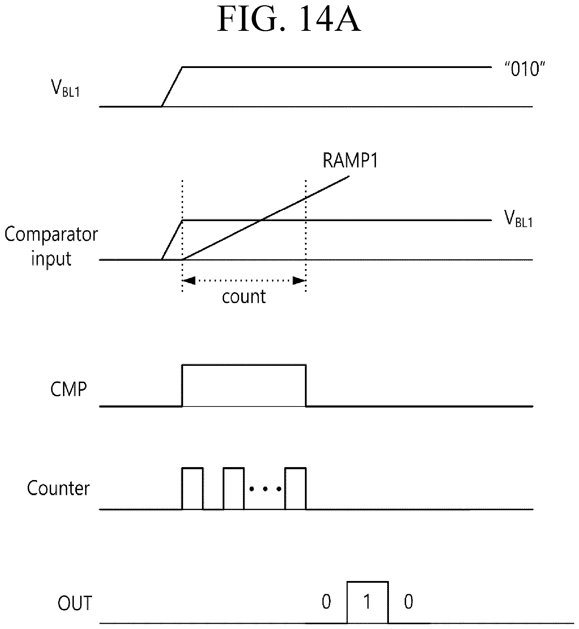

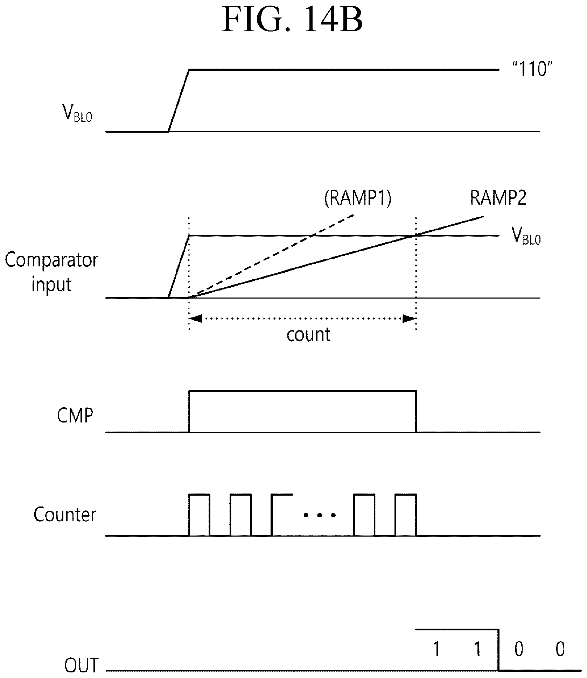

FIGS. 14A and FIG. 14B are diagrams illustrating a multiplication operation according to an example embodiment. In FIGS. 14A and FIG. 14B, a description will be provided for an example in which 3-bit data "110" is stored in ferroelectric memory cell(s) connected to a bitline BL0 and 3-bit data "010" is stored in ferroelectric memory cell(s) connected to a bitline BL1.

Referring to FIGS. 12 and FIG. 14A, in the multiplication operation mode, according to the read operation, first charges corresponding to the 3-bit data "110" may be discharged to the bitline BL0 and second charges corresponding to the 3-bit data "010" may be discharged to the bitline BL1 depending on a read operation. Accordingly, a first voltage V_{BL0} corresponding to the first charges may be applied to the bitline BL0, and a second voltage V_{BL1} corresponding to the second charges may be applied to the bitline BL1.

When the bitline BL1 is connected under the control of the control logic circuit 150, a first ramp voltage RAMP1 having a first slope may be applied to the first input terminal 1 of the ADC 120 and the second voltage V_{BL1} may be applied to the second input terminal 2 of the ADC 120.

Accordingly, the comparator 121 may compare the first ramp voltage RAMP1 with the second voltage V_{BL1} to output a comparison signal CMP, and the counter 123 may perform a counting operation and then output a digital value OUT corresponding to the number of counted clocks. The output digital value may be "010" corresponding to the 3-bit data "010."

In multiplication operation mode, as illustrated in FIG. 14B, the ramp generator 180 may generate a second ramp voltage RAMP2 having a second slope based on the digital value "010" output from the ADC 120. The second slope may have a value based on an inverse of the digital value "010" output from the ADC 120. For example, "010" is 2 in decimal, so that the ramp generator 180 may generate a second ramp voltage RAMP2 having a slope based on 1/2 (= 0.5). However, example embodiments are not limited thereto.

Then, the ADC 120 may be connected to the bitline BL0 under the control of the control logic circuit 150. Referring to FIG. 12 and FIG. 14B, the second ramp voltage RAMP2 generated by the ramp generator 180 may be applied to the first input terminal 1 of the ADC 120 and the first voltage V_{BL0} may be applied to the second input terminal 2 through the bitline BL0. In FIG. 14B, the first ramp voltage RAMP1 is represented by dashed lines to illustrate a difference in slope.

Accordingly, the comparator 121 compares the second ramp voltage RAMP2 with the first voltage V_{BL0} to output a comparison signal CMP, and the counter 123 may perform a counting operation and then output a digital value OUT corresponding to the number of counted clock. The output digital value may be "1100" corresponding to the multiplication operation result of "110" and "010."

In FIGS. 14A and FIG. 14B, a description has been provided for an example in which the bitline BL1 is first connected to the ADC 120 and the second ramp signal RAMP2 is then generated based on "010." However, example embodiments are not limited thereto. For example, when the bitline BL0 is first connected to the ADC 120, the ADC 120 may output 3-bit data "110" and the ramp generator 180 may generate the second ramp voltage RAMP2 based on "110." When the bitline BL1 is then connected to the ADC 120, the ADC 120 may output a digital value OUT corresponding to the multiplication operation result of "110" and "010" based on the second ramp voltage RAMP2 based on "110" and the second voltage V_{BL1}.

Unlike the above-described example, 3-bit data "110" may be stored in a portion of the ferroelectric memory cell(s) connected to the bitline BL0 and 3-bit data "011" may be stored in another portion of the ferroelectric memory cell(s) connected to the bitline BL0. The first voltage V_{BL0} and the second voltage V_{BL1} may be sequentially applied to the bitline BL0 in order or in reverse order, depending on a read operation. The operations after the voltage is applied to the bitline should be sufficiently understood by the above descriptions.

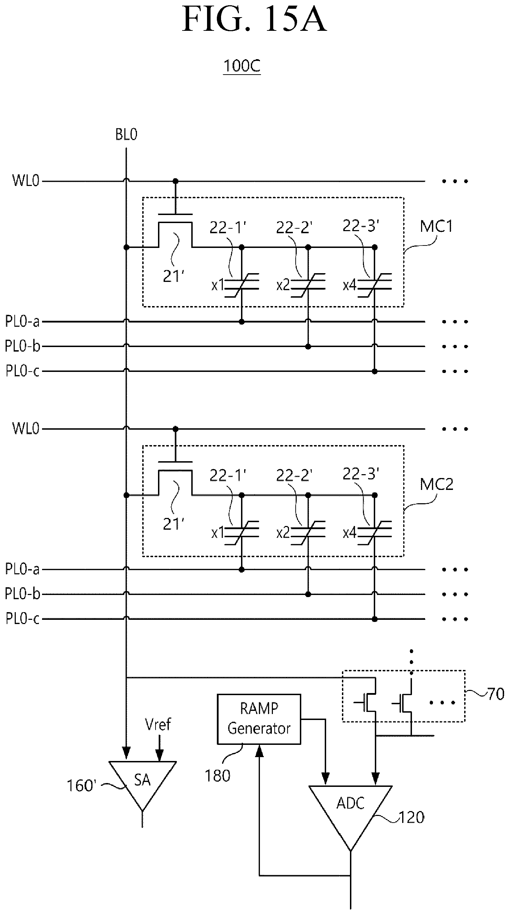

FIGS. 15A to FIG. 15D are diagrams illustrating various cases in which a calculation operation is performed according to example embodiments.

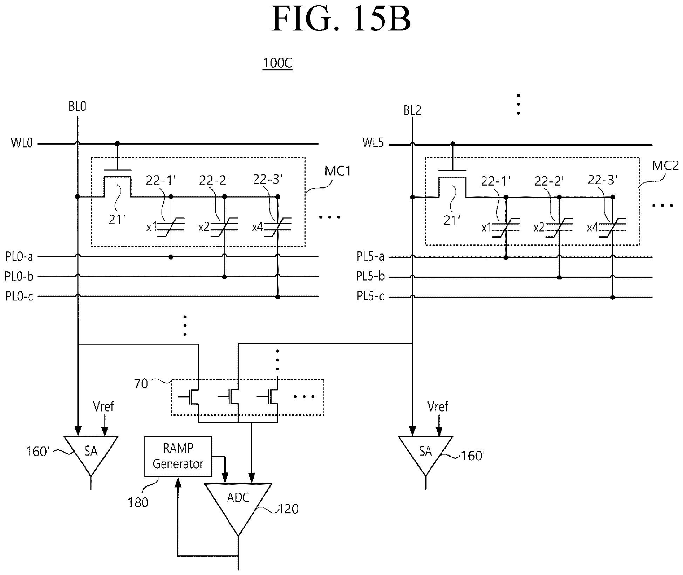

FIG. 15A illustrates a case in which first multi-bit data and second multi-bit data used for an operation are stored in two ferroelectric memory cells MC1 and MC2 connected to the same bitline BL0 in the memory device 100C of FIG. 9, and FIG. 15B illustrates a case in which first multi-bit data and second multi-bit data are stored in two ferroelectric memory cells MC1 and MC2 connected to different bitlines BL0 and BL2 in the memory device 100C of FIG. 9.

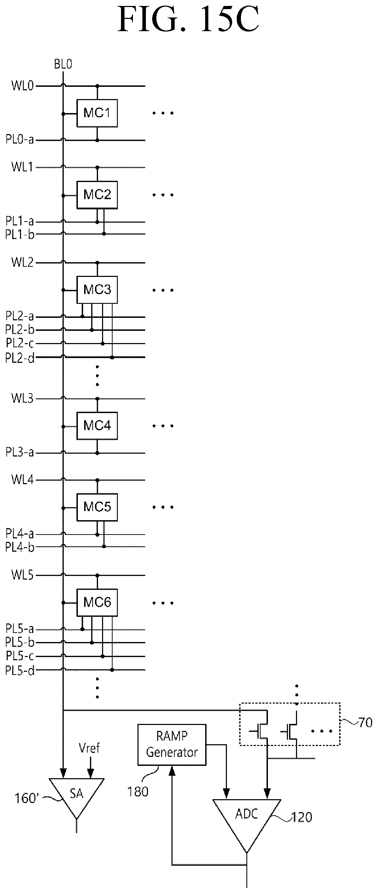

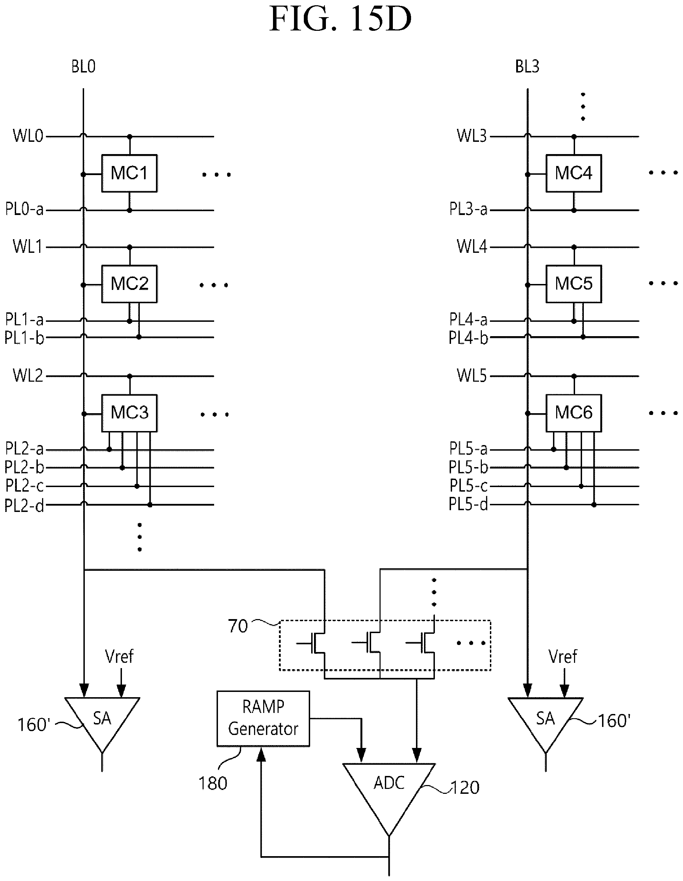

FIG. 15C illustrates a case in which the first multi-bit data and second multi-bit data are stored using six ferroelectric memory cells MC1 to MC6 connected to the same bitline BL0 in the memory device 100D of FIG. 11, and FIG. 15D illustrates a case in which first multi-bit data and second multi-bit data are stored using six ferroelectric memory cells MC1 to MC6 connected to different bitlines BL0 and BL2 in the memory device 100D of FIG. 11. Referring to FIGS. 15C and FIG. 15D, the ferroelectric memory cells MC1 and MC4 may correspond to a 2⁰ digit, the ferroelectric memory cells MC2 and MC5 may correspond to a 2¹ digit, and the ferroelectric memory cells MC3 and MC6 may correspond to a 2² digit. Accordingly, for example, one piece of 3-bit data may be stored in MC3, MC2, and MC1, and another piece of 3-bit data may be stored in MC6, MC5, and MC4.

In any of the cases of FIGS. 15A to FIG. 15D, an addition or multiplication operation may be performed on the first multi-bit data and the second multi-bit data, as described in FIGS. 12 to FIG. 14B. For example, in the addition operation, charges equal to the sum of first charges corresponding to the first multi-bit data and second charges corresponding to the second multi-bit data may be applied to the ADC 120 depending on a read operation and a bitline select signal of the control logic circuit 150. In the multiplication operation, the first charges corresponding to the first multi-bit data and the second charges corresponding to the second multi-bit data may be sequentially applied to the ADC 120 depending on the read operation and the bitline select signal of the control logic circuit 150. Accordingly, the ADC 120 may output a digital value corresponding to the addition operation result or multiplication operation result of the first multi-bit data and the second multi-bit data.

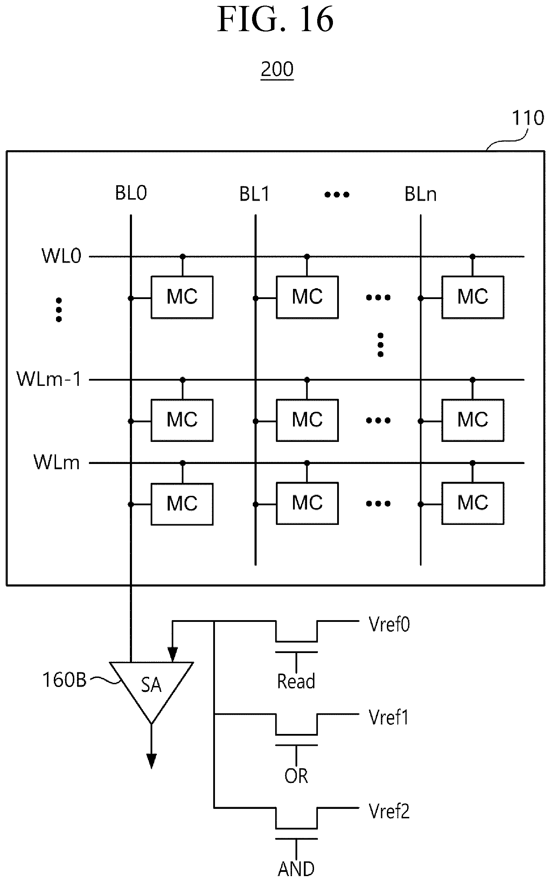

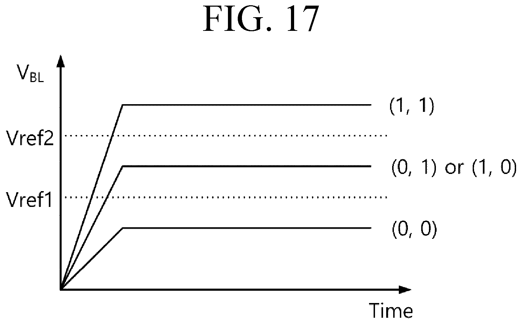

FIG. 16 is a block diagram of the memory device 200 according to an example embodiment, and FIG. 17 is a graph illustrating a bitline voltage according to an example embodiment. Referring to FIG. 16, the memory device 100 may include a memory cell array 110 and a sense amplifier 160B.

The memory cell array 110 and the ferroelectric memory cells MC included in the memory cell array 110 have been described in detail with reference to FIGS. 1 to FIG. 5C, and redundant descriptions are omitted to avoid repetition.

The sense amplifier 160B may detect data stored in the memory cell MC. For example, the sense amplifier 160B may detect data stored in the memory cell MC by comparing a bitline voltage VBL, based on charges discharged from the memory cell MC to a bitline BL0, with a reference voltage.

According to an example embodiment, the sense amplifier 160B may perform a read operation or a logic operation using a plurality of different reference voltages.

For example, in read operation mode, the sense amplifier 160B may receive a bitline voltage based on charges corresponding to single-bit data stored in the memory cell MC. The sense amplifier 160B may detect a bit value of the single-bit data based on the first reference voltage Vref0. The first reference voltage Vref0 may be the same as the reference voltage Vref of FIG. 5C, but example embodiments are not limited thereto.

In an OR operation mode, the sense amplifier 160B may receive a bitline voltage based on third charges, where the third charges are the sum of the first charges corresponding to first single-bit data and the second charges corresponding to second single-bit data. The sense amplifier 160B may output an OR operation result of the first single-bit data and the second single-bit data based on a second reference voltage Vref1.

In an AND operation mode, the sense amplifier 160B may receive a bitline voltage based on charges corresponding to the first single-bit data and the second single-bit data. The sense amplifier 160B may output an AND operation result of the first single-bit data and the second single-bit data based on a third reference voltage Vref2.

For example, in FIGS. 5A to FIG. 5C, there is a difference in charges discharged to a bitline and a bitline voltage based on the discharged charges when the single-bit data is "1" and when the single-bit data is "0." Therefore, in the OR operation mode or the AND operation mode, a bitline voltage when both first single-bit data and second single-bit data are "0," a bitline voltage when only one of the first single-bit data and the second single-bit data is "1," and a bitline voltage when both of the first single-bit data and the second single-bit data are "1" may be different from each other. Referring to FIG. 17, the number of possible cases for values of the first single-bit data and second single-bit data is four, as follows: (0, 0), (0, 1), (1, 0), and (1, 1). In an example embodiment, a bitline voltage V_{BL} may be lowest when (0, 0) and highest when (1, 1), and may have an intermediate value when (0, 1) or (1, 0).

The sense amplifier 160B may compare a bitline voltage of a connected bitline with a reference voltage to output a result of the comparison. Accordingly, when a second reference voltage Vref1, set to distinguish between the case in which both the first single-bit data and the second single-bit data are "0" and the other cases, is used as a reference voltage of the sense amplifier 160B, the sense amplifier 160B may output a result value corresponding to an OR operation result between the first single-bit data and the second single-bit data. In addition, when a third reference voltage Vref2, set to distinguish between the case in which both the first and second single-bit data are "1" and the other cases, is used as a reference voltage of the sense amplifier 160B, the sense amplifier 160B may output a result value corresponding to an AND operation result between the first single-bit data and the second single-bit data.

According to the above-described various embodiments, a ferroelectric memory device performing logic operation functions on single-bit data may be provided.

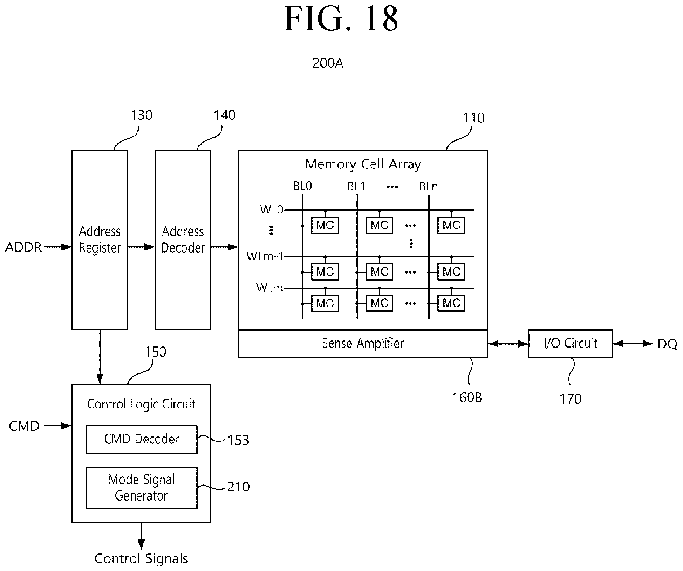

FIG. 18 is a block diagram of a memory device according to an example embodiment. A memory device 220A of FIG. 18 may be an example of implementing the memory device 200 of FIG. 16, but example embodiments are not limited thereto.

Referring to FIG. 18, the memory device 200A may include the memory cell array 110, the address register 130, the address decoder 140, the control logic circuit 150, the sense amplifier 160B, the input/output (I/O) circuit 170, and a mode signal generator 210.

The memory device 200A may include substantially the same components as the memory device 100A of FIG. 6, except that an ADC 120 is absent and the control logic circuit 150 includes the mode signal generator 210. Therefore, redundant descriptions of substantially the same components in FIG. 18 are omitted to avoid repetition.

The control logic circuit 150 may control the operation of the memory device 200A. For example, the control logic circuit 150 may generate various control signals such that the memory device 200A performs a program operation, a read operation, a logic operation, a precharge operation, a rewrite operation, or the like. For example, the control logic circuit 150 may include a mode signal generator 210 controlling the memory device 200A to operate in one of read operation mode, OR operation mode, or AND operation mode.

For example, the mode signal generator 210 may generate a read mode signal Read to apply the first reference voltage VrefU to the sense amplifier 160B in read operation mode. The mode signal generator 210 may generate an OR mode signal OR to apply the second reference voltage Vref1 to the sense amplifier 160B in OR operation mode. The mode signal generator 210 may generate an AND mode signal AND to apply the third reference voltage Vref2 to the sense amplifier 160B in AND operation mode.

The mode signal generator 210 may provide the generated mode signal to the address decoder 140. Accordingly, in read operation mode, the address decoder 140 may drive the memory cell array 110 to apply a bitline voltage based on charges corresponding to one piece of single-bit data to the sense amplifier 160B. In the OR operation mode or the AND operation mode, the address decoder 140 may drive the memory cell array 110 to apply a bitline voltage based on charges corresponding to two pieces of single-bit data to the sense amplifier 160B.

In FIG. 18, a description has been provided for an example in which the ADC 120, a component of the memory device 100A of FIG. 6, is absent. However, example embodiments are not limited thereto. According to example embodiments, the memory device 200A may include the ADC 120 described in FIG. 6.

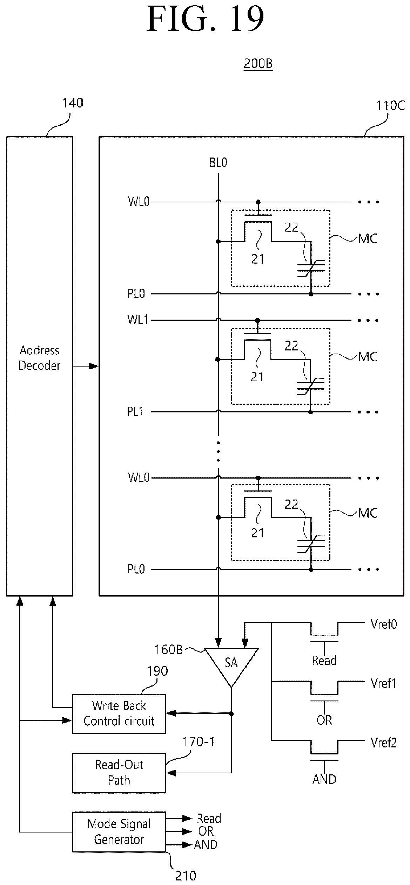

FIG. 19 is a block diagram of a memory device according to an example embodiment. The memory device 200B of FIG. 19 may be an example of implementing the memory devices 200 and 200A of FIG. 16 and FIG. 18, but example embodiments are not limited thereto. For the description of FIG. 19, redundant descriptions are omitted to avoid repetition.

Referring to FIG. 19, a memory cell array 110C may include a plurality of ferroelectric memory cells MCs. Each of the ferroelectric memory cells MCs may have a 1T1C structure.

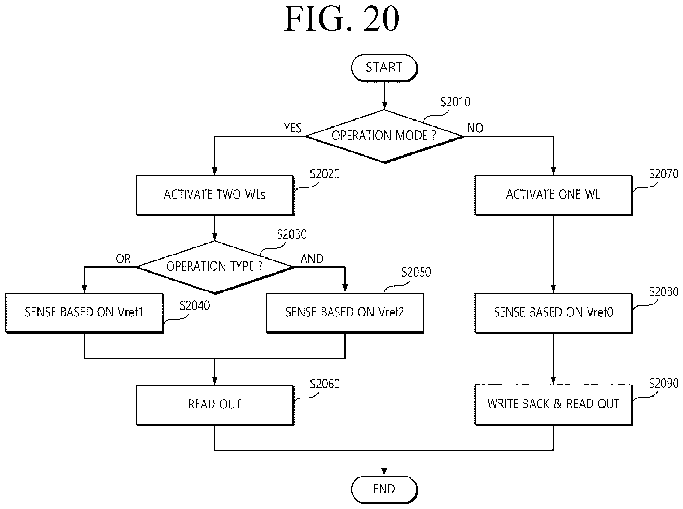

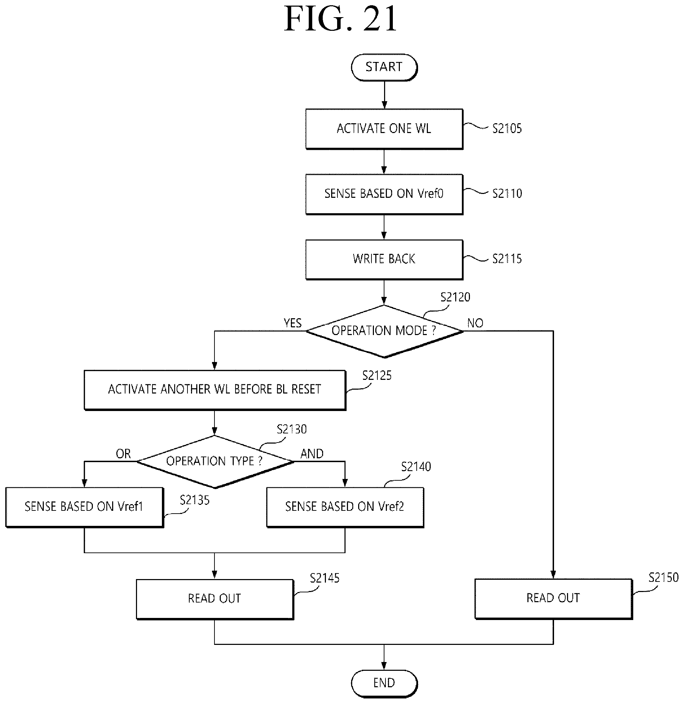

Hereinafter, a method of operating the memory device 200B according to various embodiments will be described with reference to FIGS. 20 and 21.

FIG. 20 is a flowchart illustrating an example of the method of operating the memory device of FIG. 19. Referring to FIG. 20, in operation S2010, a determination is made as to whether the memory device 200B is in operation mode. When the memory device 200B is in operation mode (S2010, YES), the flow proceeds to operation S2020 in which the address decoder 140 may activate two wordlines. Accordingly, a bitline voltage based on charges corresponding to first single-bit data and second single-bit data stored in two ferroelectric memory cells connected to the activated wordlines may be applied to the bitline BL0.

In operation S2030, the memory device 200B may determine whether the type of operation that should be performed by the memory device 200B is an OR operation or an AND operation. When the memory device 200B should perform the OR operation (S2030, OR), the flow proceeds to operation S2040 in which the sense amplifier 160B may perform a sensing operation based on a second reference voltage Vref1. For example, the sense amplifier 160B may detect a result value corresponding to an OR operation result of the first single-bit data and the second single-bit data based on the second reference voltage Vref1.

When the memory device 200B should perform the AND operation (S2030, AND), the flow proceeds to operation S2050 in which the sense amplifier 160B may perform a sensing operation based on the third reference voltage Vref2. For example, the sense amplifier 160B may detect a result value corresponding to the AND operation result of the first single-bit data and the second single-bit data based on the third reference voltage Vref2.

In operation S2060, the result value corresponding to the OR operation result or the AND operation result of the first single-bit data and the second single-bit data may be read out to the outside through the read-out path 170-1.

When the memory device 200B is not in operation mode in operation S2010 (S2010, NO), the flow proceeds to operation S2070 in which the address decoder 140 may activate a single wordline. The memory device 200B may operate in read operation mode, and a bitline voltage based on charges corresponding to the single-bit data stored in a single ferroelectric memory cell connected to the activated wordline may be applied to the bitline BL0.

Accordingly, in operation S2080, the sense amplifier 160B may perform a sensing operation based on the first reference voltage Vref0. For example, the sense amplifier 160B may detect whether a data value of the single-bit data is "1" or "0," based on the first reference voltage Vref0. In operation S2090, the write back circuit 190 may perform a rewrite operation, and the detected data value may be read out to the outside through the read-out path 170-1.

FIG. 21 is a flowchart illustrating an example of a method of operating the memory device of FIG. 19. Referring to FIG. 21, in operation S2105, the address decoder 140 may activate one of the plurality of wordlines WLs connected to the bitline BL0. Accordingly, in operation S2010, the sense amplifier 160B may perform a sensing operation based on the first reference voltage Vref0. For example, the sense amplifier 160B may detect whether the first single-bit data stored in the first ferroelectric memory cell connected to the activated wordline is "1" or "0," based on the first reference voltage Vref0. Accordingly, in operation S2115, the write back circuit 190 may reprogram the first single-bit data in the first ferroelectric memory cell.

In operation S2120, a determination is made as to whether the memory device 200B is in operation mode. When the memory device 200B is in operation mode (S2120, YES), the flow proceeds to operation S2125 in which the address decoder 140 may activate another wordline before the bitline BL0 is reset or precharged. Accordingly, the bitline voltage based on charges corresponding to the first single-bit data stored in the first ferroelectric memory cell connected to the wordline and the second single-bit data stored in the second ferroelectric memory cell connected to the another wordline may be applied to the bitline BL0.

In operation S2130, the memory device 200B may determine whether the type of operation that should be performed by the memory device 200B is an OR operation or an AND operation. When the memory device should perform the OR operation (S2130, OR), the flow proceeds to operation S2135 in which the sense amplifier 160B may perform a sensing operation based on the second reference voltage Vref1. For example, the sense amplifier 160B may detect a result value corresponding to an OR operation result of the first single-bit data and the second single-bit data based on the second reference voltage Vref1.

When the memory device 200B should perform the AND operation (S2130, AND), the flow proceeds to operation S2140 in which the sense amplifier 160B may perform a sensing operation based on the third reference voltage Vref2. For example, the sense amplifier 160B may detect a result value corresponding to an AND operation result of the first single-bit data and the second single-bit data based on the third reference voltage Vref2.

In operation S2145, the result value corresponding to the OR operation result or the AND operation result of the first single-bit data and the second single-bit data may be read out to the outside through the read-out path 170-1.

When the memory device 200B is not in operation mode in operation S2120 (S2120, NO), the flow proceeds to operation S2150 in which only the first single-bit data may be read out to the outside through the read-out path 170-1. For example, when the memory device 200B is not in operation mode, the memory device 200B operates in read operation mode for the first ferroelectric memory cell.

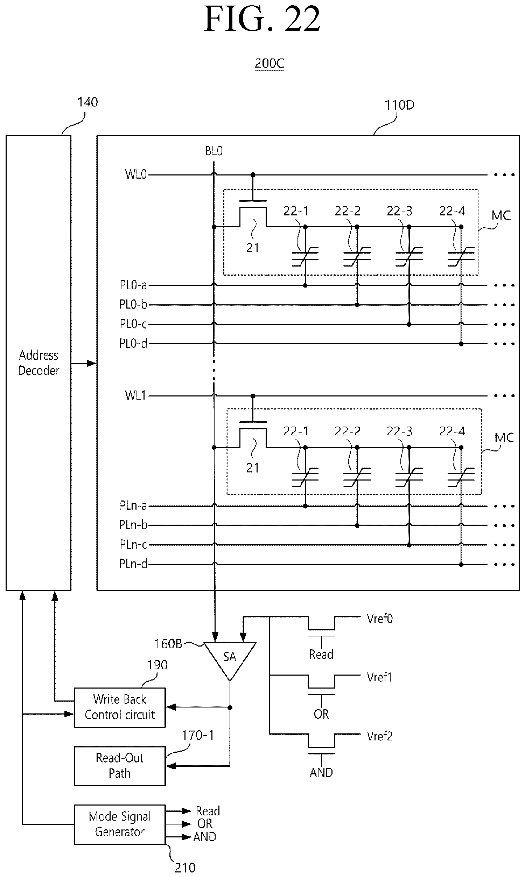

FIG. 22 is a block diagram of a memory device according to an example embodiment. A memory device 200C of FIG. 22 may be an example of implementing the memory devices 200 and 200A of FIG. 16 and FIG. 18, but example embodiments are not limited thereto. For the description of FIG. 22, redundant descriptions are omitted to avoid repetition.

Referring to FIG. 22, a memory cell array 110D may include a plurality of ferroelectric memory cells MCs. Each of the ferroelectric memory cells MCs may have a 1TnC structure. A plurality of ferroelectric capacitors 22-1 to 22-4, included in each of the ferroelectric memory cells MCs, may have the same capacitance and may each store single-bit data. In FIG. 22, each of the plurality of ferroelectric capacitors 22-1 to 22-4 may act as a memory cell storing single-bit data, which is unlike the example in FIG. 11.

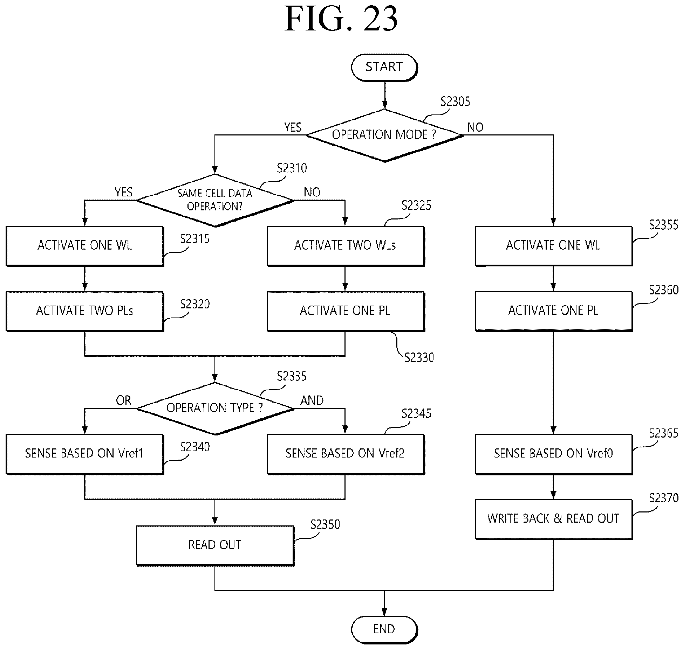

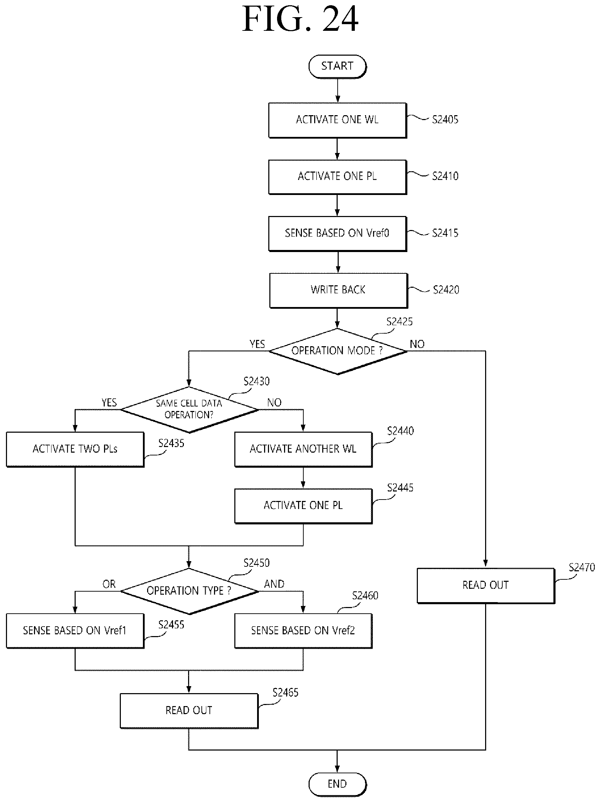

Hereinafter, a method of operating the memory device 200C according to various embodiments will be described with reference to FIGS. 23 and 24.

FIG. 23 is a flowchart illustrating an example of the method of operating the memory device of FIG. 22. Referring to FIG. 23, in operation S2305, a determination is made as to whether the memory device 200C is in operation mode. When the memory device 200C is in operation mode (S2305, YES), the flow proceeds to operation S2310 in which the memory device 200C may determine whether an operation is an operation between a plurality of pieces of data stored in ferroelectric capacitors connected to the same access transistor.

When the operation is the operation between the plurality of pieces of data stored in the ferroelectric capacitors connected to the same access transistor (S2310, YES), the flow proceeds to operation S2315 in which the address decoder 140 may activate a single wordline. In operation S2320, the address decoder 140 may activate two plate lines. Accordingly, a bitline voltage based on charges corresponding to the first single-bit data and the second single-bit data stored in a single ferroelectric memory cell may be applied to the bitline BL0.

When the operation is not the operation between the plurality of pieces of data stored in the ferroelectric capacitors connected to the same access transistor (S2310, NO), the flow proceeds to operation S2325 in which the address decoder 140 may activate two wordlines. In operation S2330, the address decoder 140 may activate a single plate line included in each of the activated two wordlines. Accordingly, a bitline voltage based on charges corresponding to the first single-bit data and the second single-bit data stored in two ferroelectric memory cells may be applied to the bitline BL0.

In operation S2335, the memory device 200C may determine whether the type of operation that should be performed by the memory device 200C is an OR operation or an AND operation. When the memory device 200C should perform the OR operation (S2335, OR), the flow proceeds to operation S2340 in which the sense amplifier 160B may perform a sensing operation based on the second reference voltage Vref1. For example, the sense amplifier 160B may detect a result value corresponding to an OR operation result of the first single-bit data and the second single-bit data based on the second reference voltage Vref1.

When the memory device 200C should perform the AND operation (S2335, AND), the flow proceeds to operation S2345 in which the sense amplifier 160B may perform a sensing operation based on the third reference voltage Vref2. For example, the sense amplifier 160B may detect a result value corresponding to an AND operation result of the first single-bit data and the second single-bit data based on the third reference voltage Vref2.

In operation S2350, a result value corresponding to the OR operation result or the AND operation result of the first single-bit data and the second single-bit data may be read out to the outside through the read-out path 170-1.

When the memory device 200C is not in operation mode in operation S2305 (S2305, NO), the flow proceeds to operation S2355 in which the address decoder 140 may activate a single wordline. In operation S2360, the address decoder 140 may activate a single plate line, among a plurality of plate lines corresponding to the activated wordline. The memory device 200C may operate in read operation mode, and a bitline voltage based on charges corresponding to one piece of single-bit data stored in a single ferroelectric memory capacitor connected to the activated wordline and plate line may be applied to the bitline BL0.

Accordingly, in operation S2365, the sense amplifier 160B may perform a sensing operation based on the first reference voltage Vref0. For example, the sense amplifier 160B may detect whether a data value of the single-bit data is "1" or "0," based on the first reference voltage Vref0. In operation S2370, the write back circuit 190 may perform a rewrite operation, and the detected data value may be read out to the outside through the read-out path 170-1.

FIG. 24 is a flowchart illustrating an example of a method of operating the memory device of FIG. 22. Referring to FIG. 24, in operation S2405, the address decoder 140 may activate a single wordline, among a plurality of wordlines WLs connected to a bitline BL0. In operation S2410, the address decoder 140 may activate a single plate line, among a plurality of plate lines corresponding to the activated wordline.

Accordingly, in operation S2415, the sense amplifier 160B may perform a sensing operation based on the first reference voltage Vref0. For example, the sense amplifier 160B may detect whether the single-bit data stored in the ferroelectric memory cell connected to the activated wordline and plate line is "1" or "0," based on the first reference voltage Vref0. Accordingly, in operation S2420, the write back circuit 190 may reprogram the single-bit data in the ferroelectric memory cell.

In operation S2425, a determination is made as to whether the memory device 200C is in operation mode. When the memory device 200C is in operation mode (S2425, YES), the flow proceeds to operation S2430 in which the memory device 200C may determine whether an operation is an operation between a plurality of pieces of data stored in ferroelectric capacitors connected to the same access transistor. When the operation is the operation between the plurality of pieces of data stored in the ferroelectric capacitors connected to the same access transistor (S2430, YES), the flow proceeds to operation S2435 in which the address decoder 140 may activate two plate lines. Accordingly, a bitline voltage based on charges corresponding to the first single-bit data and the second single-bit data stored in a single ferroelectric memory cell may be applied to the bitline BL0.

When the operation is not the operation between the plurality of pieces of data stored in the ferroelectric capacitors connected to the same access transistor (S2430, NO), the flow proceeds to operation S2440 in which the address decoder 140 may activate a wordline, different from the single wordline activated in operation S2405. In operation S2445, the address decoder 140 may activate a single plate line, among a plurality of plate lines corresponding to the other wordline. Accordingly, the bitline voltage based on charges corresponding to the first single-bit data and the second single-bit data stored in the two ferroelectric memory cells connected to the two wordlines, respectively activated in operations S2405 and S2440, may be applied to the bitline BL0.

In operation S2450, the memory device 200C may determine whether the type of operation that should be performed by the memory device 200C is an OR operation or an AND operation. When the memory device 200C should perform the OR operation (S2450, OR), the flow proceeds to operation S2455 in which the sense amplifier 160B may perform a sensing operation based on the second reference voltage Vref1. For example, the sense amplifier 160B may detect a result value corresponding to an OR operation result of the first single-bit data and the second single-bit data based on the second reference voltage Vref1.

When the memory device 200C should perform the AND operation (S2450, AND), the flow proceeds to operation S2460 in which the sense amplifier 160B may perform a sensing operation based on the third reference voltage Vref2. For example, the sense amplifier 160B may detect a result value corresponding to an AND operation result of the first single-bit data and the second single-bit data based on the third reference voltage Vref2.

In operation S2465, the result value corresponding to the OR operation result or the AND operation result of the first single-bit data and the second single-bit data may be read out to the outside through the read-out path 170-1.

When the memory device 200C is not in operation mode in operation S2425 (S2425, NO), the flow proceeds to operation 2470 in which only the single-bit data may be read out to the outside through the read-out path 170-1. The read-out single-bit data may be data stored in the ferroelectric memory cell connected to the wordline and plate line activated in operations S2405 and S2410. For example, when the memory device 200C is not in operation mode, the memory device 200C may operates in read operation mode.

According to the above-described various embodiments, a ferroelectric memory device capable of performing operation functions on multi-bit data may be provided.

As set forth above, according to example embodiments, a ferroelectric memory device performing operation functions on multi-bit data may be provided.

## Claims

1. A memory device (100, 200) comprising:
a memory cell array (110) comprising a plurality of ferroelectric memory cells (MC), respectively disposed at intersections of wordlines (WL0-WLm) and bitlines (BL0-BLn); and
an analog-to-digital converter, ADC (120), selectively connected to the bitlines (BL0-BLn) and configured to output a digital value corresponding to charges applied through at least one bitline of the bitlines (BL0-BLn),
wherein the charges correspond to at least one piece of multi-bit data having a plurality of digits stored in a portion of the plurality of ferroelectric memory cells (MC) that are connected to the at least one bitline.

2. The memory device (100, 200) of claim 1, wherein each of the plurality of ferroelectric memory cells (MC) comprises:
a plurality of ferroelectric capacitors (22), each having a first end connected to a respective plate line of a plurality of plate lines (PLO-a, PL0-b, PL0-c); and
an access transistor (21) having a control electrode connected to a wordline among the wordlines (WL0-WLm), a first electrode connected to a bitline (BL0) among the bitlines (BL0-BLn), and a second electrode commonly connected to a second end of each of the plurality of ferroelectric capacitors (22).

3. The memory device (100, 200) of claim 2, wherein the plurality of ferroelectric capacitors (22) have different capacitances and correspond to respective digits of multi-bit data.

4. The memory device (100, 200) of claim 3, wherein the different capacitances of the plurality of ferroelectric capacitors (22) increase in a direction toward higher corresponding digits of the multi-bit data.

5. The memory device (100, 200) of any one of claims 2 to 4, wherein the plurality of ferroelectric capacitors (22A-1) comprise:
a cylindrical inner electrode (31);
a ferroelectric layer (32) surrounding an outer peripheral surface of the cylindrical inner electrode (31); and
a plurality of outer electrodes (33-1, 33-2, 33-3) surrounding an outer peripheral surface of the ferroelectric layer (32), the plurality of outer electrodes (33-1, 33-2, 33-3) corresponding respectively to the plurality of ferroelectric capacitors (22), and
wherein the plurality of outer electrodes (33-1, 33-2, 33-3) have different heights and are separated from each other in an axial direction.

6. The memory device (100, 200) of claim 5, wherein:
the cylindrical inner electrode (31) is connected to the second electrode of the access transistor (21), and
the plurality of outer electrodes (33-1, 33-2, 33-3) are connected to the plurality of plate lines (PLO-a, PL0-b, PLO-c), respectively.

7. The memory device (100, 200) of any one of claims 2 to 4, wherein the plurality of ferroelectric capacitors (22A-2) comprise:
a first planar electrode (41);
a ferroelectric layer (42) stacked on the first planar electrode (41); and
a plurality of second planar electrodes (43-1, 43-2, 43-3) stacked on the ferroelectric layer (42) and respectively corresponding to the plurality of ferroelectric capacitors (22), and
wherein the plurality of second planar electrodes (43-1, 43-2, 43-3) have different widths and are separated from each other.

8. The memory device (100, 200) of claim 7, wherein:
the first planar electrode (41) is connected to the second electrode of the access transistor (21), and
the plurality of second planar electrodes (43-1, 43-2, 43-3) are connected to the plurality of plate lines (PLO-a, PL0-b, PLO-c), respectively.

9. The memory device (100, 200) of any one of claims 2 to 8, wherein:
the plurality of ferroelectric memory cells (MC) comprise a plurality of types of ferroelectric memory cells (MC), respectively corresponding to the plurality of digits of the multi-bit data, and
the plurality of types of ferroelectric memory cells (MC) each comprise a same number of the plurality of ferroelectric capacitors (22), and are controlled by a different number of the plurality of plate lines (PLO-a, PL0-b, PL0-c) depending on corresponding digits.

10. The memory device (100, 200) of claim 9, wherein, for each of the plurality of types of ferroelectric memory cells (MC), the plurality of ferroelectric capacitors (22) included in the, e.g. same, ferroelectric memory cell or in all ferroelectric memory cells (MC) have a same capacitance.

11. The memory device (100, 200) of claim 9 or 10, wherein:
a ferroelectric memory cell of the plurality of ferroelectric memory cells (MC) and corresponding to a first digit, among the plurality of digits of the multi-bit data, is controlled by a first number of the plurality of plate lines (PLO-a, PL0-b, PLO-c), and
a ferroelectric memory cell of the plurality of ferroelectric memory cells (MC) and corresponding to a second bit having a higher digit value than the first digit, among the plurality of digits of the multi-bit data, is controlled by a second number of plurality of plate lines (PL0-a, PL0-b, PL0-c) that is greater than the first number.

12. The memory device (100, 200) of any one of claims 1 to 11, further comprising:
a ramp generator (180) configured to generate a ramp voltage,
wherein the ADC (120) outputs the digital value based on the ramp voltage and a voltage corresponding to the charges.

13. The memory device (100, 200) of claim 12, wherein:
the ramp generator (180) generates a first ramp voltage (RAMP1) having a first slope, and
the ADC (120), in an addition operation mode, receives a first voltage (VBL0) based on charges corresponding to first multi-bit data and second multi-bit data, and outputs the digital value corresponding to an addition operation result of the first multi-bit data and the second multi-bit data based on the first ramp voltage (RAMP1) and the first voltage (VBL0).

14. The memory device (100, 200) of claim 12, wherein:
the ramp generator (180) generates a second ramp voltage (RAMP2) having a second slope based on the digital value, output by the ADC (120) and corresponding to first multi-bit data, in a multiplication operation mode, and
the ADC (120), when receiving a second voltage (VBL1) based on charges corresponding to second multi-bit data, outputs the digital value corresponding to the first multi-bit data and the second multi-bit data based on the second ramp voltage (RAMP2) and the second voltage (VBL1) in the multiplication operation mode.

15. The memory device (100, 200) of claim 14, wherein:
the ramp generator (180) generates a first ramp voltage (RAMP1) having a first slope before the ADC (120) outputs the digital value corresponding to the first multi-bit data in the multiplication operation mode, and
the ADC (120) receives a third voltage (VBL0+VBL1) based on a charge corresponding to the first multi-bit data before the second voltage (VBL1) is applied and outputs the digital value corresponding to the first multi-bit data based on the first ramp voltage (RAMP1) and the third voltage (VBL0+VBL1) in the multiplication operation mode.
